(19) Europäisches Patentamt
European Patent Office
Office européen des brevets

(11) EP 3 267 256 A1

(12) EUROPEAN PATENT APPLICATION
published in accordance with Art. 153(4) EPC

(43) Date of publication:
10.01.2018 Bulletin 2018/02

(21) Application number: 16758775.7

(22) Date of filing: 19.02.2016

(51) Int Cl.:
G03F 7/11 (2006.01) C08G 14/12 (2006.01)
G03F 7/40 (2006.01) H01L 21/027 (2006.01)

(86) International application number:
PCT/JP2016/054824

(87) International publication number:
WO 2016/140081 (09.09.2016 Gazette 2016/36)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD

(30) Priority: 03.03.2015 JP 2015041370

(71) Applicant: Mitsubishi Gas Chemical Company, Inc.
Tokyo 100-8324 (JP)

(72) Inventors:
- OKADA, Kana
Hiratsuka-shi
Kanagawa 254-0016 (JP)
- MAKINOSHIMA, Takashi
Hiratsuka-shi
Kanagawa 254-0016 (JP)
- ECHIGO, Masatoshi
Tokyo 100-8324 (JP)
- HIGASHIHARA, Go
Kurashiki-shi
Okayama 712-8525 (JP)
- OKOSHI, Atsushi
Kurashiki-shi
Okayama 712-8525 (JP)

(74) Representative: Müller-Boré & Partner
Patentanwälte PartG mbB
Friedenheimer Brücke 21
80639 München (DE)

# (54) UNDERLAYER FILM-FORMING MATERIAL FOR LITHOGRAPHY, UNDERLAYER FILM-FORMING COMPOSITION FOR LITHOGRAPHY, UNDERLAYER FILM FOR LITHOGRAPHY, RESIST PATTERN-FORMING METHOD, AND CIRCUIT PATTERN-FORMING METHOD

(57) The present invention provides a material for forming an underlayer film for lithography, including a cyanic acid ester compound obtained by cyanation of a modified naphthalene formaldehyde resin.

EP 3 267 256 A1

## Description

### Technical Field

The present invention relates to a material for forming an underlayer film for lithography, a composition for forming an underlayer film for lithography, an underlayer film for lithography, a resist pattern forming method, and a circuit pattern forming method.

### Background Art

Semiconductor devices are manufactured through microfabrication by lithography using a photoresist material, but are required to be made finer by a pattern rule in accordance with the increase in integration degree and the increase in speed of LSI in recent years. In lithography using exposure to light, which is currently used as a general-purpose technique, the resolution is now approaching the intrinsic limitation associated with the wavelength of the light source.

A light source for lithography, for use in forming a resist pattern, has a shorter wavelength from a KrF excimer laser (248 nm) to an ArF excimer laser (193 nm). However, as the resist pattern is made finer and finer, there arise a problem of resolution and a problem of collapse of the resist pattern after development, and therefore there is demanded for making a resist film thinner. If the resist film is merely made thinner, however, it is difficult to achieve the resist pattern having a film thickness sufficient for processing a substrate. Accordingly, there has been increasingly required a process in which not only the resist pattern but also a resist underlayer film is prepared between a resist and a semiconductor substrate to be processed and the resist underlayer film is allowed to have a function as a mask at the time of processing the substrate.

Currently, as the resist underlayer film for such a process, various ones are known. For example, as one that realizes a resist underlayer film for lithography, having a selection ratio of dry etching rate close to the resist, unlike a conventional resist underlayer film having a high etching rate, there has been proposed a material for forming an underlayer film for multilayer resist process, containing a resin component having at least a substituent which releases a terminal group to form a sulfonic acid residue when a predetermined energy is applied, and a solvent (see, for example, Patent Literature 1). In addition, as one that realizes a resist underlayer film for lithography, having a smaller selection ratio of dry etching rate than the resist, there has been proposed a resist underlayer film material including a polymer having a specified repeating unit (see, for example, Patent Literature 2). Furthermore, as one that realizes a resist underlayer film for lithography, having a smaller selection ratio of dry etching rate than the semiconductor substrate, there has been proposed a resist underlayer film material including a polymer formed by co-polymerizing a repeating unit of acenaphthylene, and a substituted or non-substituted repeating unit having a hydroxy group (see, for example, Patent Literature 3).

On the other hand, as a material for allowing such a resist underlayer film to have a high etching resistance, an amorphous carbon underlayer film is well known, which is formed by CVD using methane gas, ethane gas, acetylene gas, or the like as a raw material.

In addition, as a material that is excellent in optical characteristics and etching resistance and that is capable of being dissolved in a solvent and being applied to a wet process, there has been proposed a composition for forming an underlayer film for lithography (see, for example, Patent Literatures 4 and 5.), which contains a naphthalene formaldehyde polymer including a specified constituent unit, and an organic solvent.

Meanwhile, with respect to a forming method of an intermediate layer for use in forming a resist underlayer film in a three-layer process, for example, known are a forming method of a silicon nitride film (see, for example, Patent Literature 6), and a CVD forming method of a silicon nitride film (see, for example, Patent Literature 7). In addition, as an intermediate layer material for a three-layer process, known is a material containing a silsesquioxane-based silicon compound (see, for example, Patent Literatures 8 and 9).

### Citation List

### Patent Literature

Patent Literature 1: Japanese Patent Laid-Open No. 2004-177668
Patent Literature 2: Japanese Patent Laid-Open No. 2004-271838
Patent Literature 3: Japanese Patent Laid-Open No. 2005-250434
Patent Literature 4: International Publication No. WO 2009/072465
Patent Literature 5: International Publication No. WO 2011/034062

Patent Literature 6: Japanese Patent Laid-Open No. 2002-334869
Patent Literature 7: International Publication No. WO 2004/066377
Patent Literature 8: Japanese Patent Laid-Open No. 2007-226170
Patent Literature 9: Japanese Patent Laid-Open No. 2007-226204

## Summary of Invention

### Technical Problem

As described above, many materials for forming an underlayer film for lithography have been conventionally proposed, but there are no ones that not only have such a high solvent solubility as to be able to be applied to a wet process such as a spin coating method or screen printing, but also simultaneously satisfy heat resistance and etching resistance at a high level, and thus a new material is required to be developed.

The present invention has been then made in view of the above problem, and an object thereof is to provide a material for forming an underlayer film for lithography, which can be applied to a wet process and which is useful for forming a photoresist underlayer film excellent in heat resistance and etching resistance.

### Solution to Problem

The present inventors have intensively studied to solve the above problem of the prior art, and as a result, have found that a material for forming an underlayer film, including a cyanic acid ester compound obtained by cyanation of a modified naphthalene formaldehyde resin, is used to thereby provide a photoresist underlayer film excellent in heat resistance and etching resistance, thereby leading to the completion of the present invention. That is, the present invention is as follows.

[1] A material for forming an underlayer film for lithography, comprising a cyanic acid ester compound obtained by cyanation of a modified naphthalene formaldehyde resin.

[2] The material for forming the underlayer film for lithography according to [1], wherein the cyanic acid ester compound is a compound represented by following formula (1);

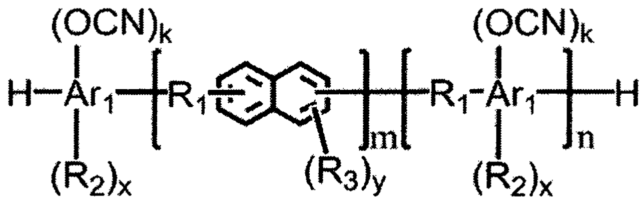

(1)

wherein each $Ar_1$ independently represents an aromatic ring structure, each $R_1$ independently represents a methylene group, a methyleneoxy group, a methyleneoxymethylene group or an oxymethylene group, or a combination thereof, each $R_2$ independently represents a hydrogen atom, an alkyl group or an aryl group as a monovalent substituent, each $R_3$ independently represents an alkyl group having 1 to 3 carbon atoms, an aryl group, a hydroxy group, or a hydroxymethylene group, m represents an integer of 1 or more, n represents an integer of 0 or more, each repeating unit is arranged in any manner; k represents an integer of 1 to 3 as the number of cyanato group(s) bonded, x represents an integer of "the number of $Ar_1$ which can be bonded - (k+2)" as the number of $R_2$ bonded, and y represents an integer of 0 to 4.

[3] The material for forming the underlayer film for lithography according to [1] or [2], wherein the modified naphthalene formaldehyde resin is a resin obtained by modifying a naphthalene formaldehyde resin or a deacetalized naphthalene formaldehyde resin by use of a hydroxy-substituted aromatic compound.

[4] The material for forming the underlayer film for lithography according to [3], wherein the hydroxy-substituted aromatic compound is at least one selected from the group consisting of phenol, 2,6-xylenol, naphthol, dihydroxynaphthalene, biphenol, hydroxyanthracene and dihydroxyanthracene.

[5] The material for forming the underlayer film for lithography according to any of [1] to [4], wherein a weight average molecular weight of the cyanic acid ester compound is 200 or more and 25000 or less.

[6] The material for forming the underlayer film for lithography according to any of [2] to [5], wherein the compound represented by the formula (1) is a compound represented by following formula (1-1);

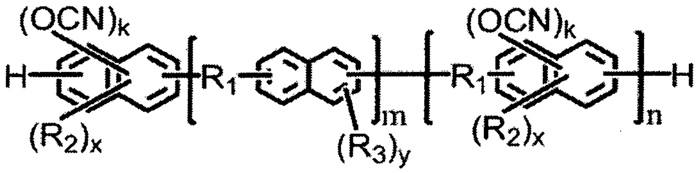

(1 − 1)

wherein $R_1$ to $R_3$, k, m, n and y are the same as those described in the formula (1), and x represents an integer of (6-k).
[7] The material for forming the underlayer film for lithography according to [6], wherein the compound represented by the formula (1-1) is a compound represented by the following formula (1-2);

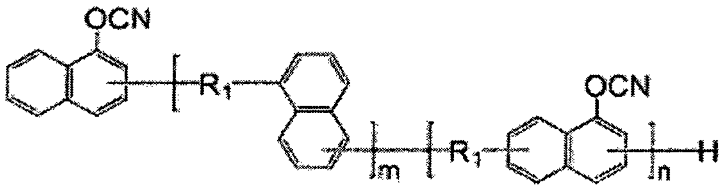

(1 − 2)

wherein $R_1$, m and n are the same as those described in the formula (1).
[8] A composition for forming an underlayer film for lithography, comprising the material for forming the underlayer film for lithography according to any of [1] to [7], and a solvent.
[9] The composition for forming the underlayer film for lithography according to [8], further comprising an acid generator.
[10] The composition for forming the underlayer film for lithography according to [8] or [9], further comprising a crosslinking agent.
[11] An underlayer film for lithography, formed using the composition for forming the underlayer film for lithography according to any of [8] to [10].
[12] A resist pattern forming method comprising:

a step of forming an underlayer film on a substrate by using the composition for forming the underlayer film according to any of [8] to [10];
a step of forming at least one photoresist layer on the underlayer film; and
a step of irradiating a predetermined region of the photoresist layer with radiation, and developing it.

[13] A circuit pattern forming method comprising:

a step of forming an underlayer film on a substrate by using the composition for forming the underlayer film according to any of [8] to [10];
a step of forming an intermediate layer film on the underlayer film by using a silicon atom-containing resist intermediate layer film material;
a step of forming at least one photoresist layer on the intermediate layer film;
a step of irradiating a predetermined region of the photoresist layer with radiation, to form a resist pattern by developing;
a step of etching the intermediate layer film with the resist pattern as a mask, to form an intermediate layer film pattern;
a step of etching the underlayer film with the intermediate layer film pattern as an etching mask, to form an underlayer film pattern; and
a step of etching the substrate with the underlayer film pattern as an etching mask, to form a substrate pattern.

Advantageous Effects of Invention

The material for forming an underlayer film for lithography of the present invention can be applied to a wet process, and is useful for forming a photoresist underlayer film excellent in heat resistance and etching resistance.

Description of Embodiments

Hereinafter, an embodiment (hereinafter, simply referred to as "the present embodiment") of the present invention will be described. It is to be noted that the following present embodiments are illustrative for describing the present invention, and the present invention is not limited only to the present embodiments.

[Material for forming underlayer film for lithography]

A material for forming an underlayer film for lithography of the present embodiment (hereinafter, simply also referred to as "material for forming an underlayer film".) includes a cyanic acid ester compound obtained by cyanation of a modified naphthalene formaldehyde resin. The material for forming an underlayer film for lithography of the present embodiment can be applied to a wet process. In addition, the material for forming an underlayer film for lithography of the present embodiment has an aromatic structure and also a cyanate group, and the cyanate group even by itself allows a crosslinking reaction thereof to occur due to high-temperature baking, thereby allowing a high heat resistance to be exhibited. As a result, an underlayer film can be formed which is inhibited from being degraded at high-temperature baking and which is also excellent in etching resistance to oxygen plasma etching or the like. Furthermore, the material for forming an underlayer film for lithography of the present embodiment has a high solubility in an organic solvent, has a high solubility in a safe solvent, is excellent in embedding property in a stepped substrate and film flatness, and has a good product quality stability, regardless of having an aromatic structure. Additionally, the material for forming an underlayer film for lithography of the present embodiment is also excellent in adhesiveness with a resist layer and a resist intermediate layer film material, and therefore can provide an excellent resist pattern.

[Modified naphthalene formaldehyde resin]

A modified naphthalene formaldehyde resin in the present embodiment is obtained by modifying a naphthalene formaldehyde resin or a deacetalized naphthalene formaldehyde resin by, for example, a hydroxy-substituted aromatic compound represented by the following formula (2).

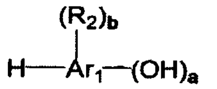

(2)

In formula (2), $Ar_1$ represents an aromatic ring structure; each $R_2$ independently represents a hydrogen atom, an alkyl group or an aryl group as a monovalent substituent; the position of the substituent of the aromatic ring can be arbitrarily selected; a represents an integer of 1 to 3 as the number of hydroxy group(s) bonded; and b represents, as the number of R bonded, (5-a), (7-a), and (9-a), when $Ar_1$ represents a benzene structure, a naphthalene structure, and a biphenylene structure, respectively.

Herein, the naphthalene formaldehyde resin is one obtained by a condensation reaction of a naphthalene compound and formaldehyde in the presence of an acidic catalyst, and the deacetalized naphthalene formaldehyde resin is one obtained by a treatment of a naphthalene formaldehyde resin in the presence of water and an acidic catalyst.

Hereinafter, the naphthalene formaldehyde resin, the deacetalized naphthalene formaldehyde resin and the modified naphthalene formaldehyde resin will be described.

[Naphthalene formaldehyde resin and production method thereof]

The naphthalene formaldehyde resin is a resin obtained by a condensation reaction of a naphthalene compound and formaldehyde in the presence of an acidic catalyst.

The naphthalene compound for use in the condensation reaction is naphthalene and/or naphthalene methanol. Naphthalene and naphthalene methanol are not particularly limited, and those which are industrially available can be utilized therefor.

The formaldehyde for use in the condensation reaction is not particularly limited, and examples include an aqueous formaldehyde solution which is industrially available. In addition thereto, a compound which generates formaldehyde, such as paraformaldehyde and trioxane, can also be used. An aqueous formaldehyde solution is preferable from the viewpoint of suppression of gelation.

The molar ratio of the naphthalene compound and the formaldehyde in the condensation reaction is preferably 1:1 to 1:20, more preferably 1:1.5 to 1:17.5, further preferably 1:2 to 1:15, still more preferably 1:2 to 1:12.5, further more preferably 1:2 to 1:10. Such a molar ratio range tends to enable the yield of the obtained naphthalene formaldehyde resin to be kept at a relatively high value, and enable the amount of the unreacted remaining formaldehyde to be smaller.

The acidic catalyst for use in the condensation reaction can be a well-known inorganic acid or organic acid, and examples thereof include inorganic acids such as hydrochloric acid, sulfuric acid, phosphoric acid, hydrobromic acid and hydrofluoric acid, organic acids such as oxalic acid, malonic acid, succinic acid, adipic acid, sebacic acid, citric acid,

fumaric acid, maleic acid, formic acid, p-toluenesulfonic acid, methanesulfonic acid, trifluoroacetic acid, dichloroacetic acid, trichloroacetic acid, trifluoromethanesulfonic acid, benzenesulfonic acid, naphthalenesulfonic acid and naphthalenedisulfonic acid, Lewis acids such as zinc chloride, aluminum chloride, iron chloride and boron trifluoride, and solid acids such as tungstosilicic acid, phosphotungstic acid, silicomolybdic acid and phosphomolybdic acid. Among them, sulfuric acid, oxalic acid, citric acid, p-toluenesulfonic acid, methanesulfonic acid, trifluoromethanesulfonic acid, benzenesulfonic acid, naphthalenesulfonic acid, naphthalenedisulfonic acid and phosphotungstic acid are preferable in terms of production.

The amount of the acidic catalyst to be used is preferably 0.0001 parts by mass or more and 100 parts by mass or less, more preferably 0.001 parts by mass or more and 85 parts by mass or less, further preferably 0.001 parts by mass or more and 70 parts by mass or less based on the total amount (100 parts by mass) of the naphthalene compound and the formaldehyde. Such an amount range tends to enable a proper reaction rate to be achieved, and enable an increase in resin viscosity due to a high reaction rate to be prevented. The acidic catalyst may also be charged at one time or in portions.

The condensation reaction is preferably performed under ordinary pressure in the presence of the acidic catalyst with heating under reflux or with distillation off of water produced, at a temperature where raw materials used are compatible with each other, or higher (more preferably, 80 to 300°C). The reaction pressure may be ordinary pressure or increased pressure. If necessary, an inert gas such as nitrogen, helium or argon may be allowed to flow into the system.

If necessary, a solvent inert to the condensation reaction can also be used. Examples of the solvent include aromatic hydrocarbon-based solvents such as toluene, ethylbenzene and xylene; saturated aliphatic hydrocarbon-based solvents such as heptane and hexane, alicyclic hydrocarbon-based solvents such as cyclohexane; ether-based solvents such as dioxane and dibutyl ether; ketone-based solvents such as methyl isobutyl ketone; carboxylic acid ester-based solvents such as ethyl propionate; and carboxylic acid-based solvents such as acetic acid.

The condensation reaction is not particularly limited, but, in the case of coexistence with alcohol, a naphthalene formaldehyde resin is obtained whose terminal is blocked by the alcohol and which has a low molecular weight and a low dispersibility (low molecular weight distribution), and the resulting resin is a resin good in solvent solubility and low in melt viscosity even after modification. Therefore, the condensation reaction is preferably performed under the coexistence with alcohol. The alcohol is not particularly limited, and examples thereof include monool having 1 to 12 carbon atoms and diol having 1 to 12 carbon atoms. The alcohol may be added singly or in combinations of a plurality thereof. Among them, propanol, butanol, octanol, and 2-ethylhexanol are preferable in terms of productivity of the naphthalene formaldehyde resin. In the case of coexistence with alcohol, the amount of the alcohol to be used is not particularly limited, but it is, for example, preferably 1 to 10 equivalents of the hydroxyl group of the alcohol based on 1 equivalent of the methylol group of the naphthalene methanol.

The condensation reaction may be a condensation reaction in which the naphthalene compound, the formaldehyde and the acidic catalyst are simultaneously added to the reaction system, or a condensation reaction in which the naphthalene compound is sequentially added in the system where the formaldehyde and the acidic catalyst are present. The method for sequential addition is preferable from the viewpoint that the oxygen concentration in the resulting resin can be increased to allow the reaction with the hydroxy-substituted aromatic compound in the subsequent modification step to be more performed.

The reaction time in the condensation reaction is preferably 0.5 to 30 hours, more preferably 0.5 to 20 hours, further preferably 0.5 to 10 hours. Such a reaction time range tends to allow a resin having objective properties to be economically and industrially advantageously obtained.

The reaction temperature in the condensation reaction is preferably 80 to 300°C, more preferably 85 to 270°C, further preferably 90 to 240°C. Such a reaction temperature range tends to allow a resin having objective properties to be economically and industrially advantageously obtained.

After completion of the reaction, the naphthalene formaldehyde resin is obtained by further adding, if necessary, the solvent for dilution, thereafter leaving the resultant to still stand for two-phase separation to thereby separate a resin phase as an oil phase and an aqueous phase, thereafter further performing washing with water to thereby completely remove the acidic catalyst, and removing the solvent added and the unreacted raw materials by a common method such as distillation.

In the naphthalene formaldehyde resin obtained by the reaction, the naphthalene ring is at least partially crosslinked by bond(s) represented by the following formula (3) and/or the following formula (4).

$$-\left[ CH_2 \right]_c- \quad (3)$$

In formula (3), c represents an integer of 1 to 10.

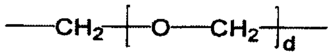 (4)

In formula (4), d represents an integer of 0 to 10.

Alternatively, the naphthalene ring may be at least partially crosslinked by a bond including the bond represented by the formula (3) and a bond represented by the following formula (5) randomly aligned, for example, any bond represented by the following formulae (6), (7) and (8).

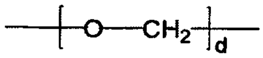 (5)

In formula (5), d represents an integer of 0 to 10.

$-CH_2-O-CH_2-CH_2-$ (6)

$-CH_2-CH_2-O-CH_2-$ (7)

$-CH_2-O-CH_2-O-CH_2-CH_2-$ (8)

[Deacetalized naphthalene formaldehyde resin and production method thereof]

The deacetalized naphthalene formaldehyde resin is obtained by treating the naphthalene formaldehyde resin in the presence of water and an acidic catalyst. In the present embodiment, such a treatment is referred to as the "deacetalization".

The deacetalized naphthalene formaldehyde resin refers to one in which the number of bonds between oxymethylene groups via no naphthalene ring is decreased by the deacetalization to result in reduction in the value(s) of c in the formula (3) and/or d in the formula (4). The deacetalized naphthalene formaldehyde resin thus obtained is increased in the amount of the residue in pyrolysis of the resin obtained after modification, namely, is reduced in mass loss rate, as compared with the naphthalene formaldehyde resin.

The above naphthalene formaldehyde resin can be used for the deacetalization.

The acidic catalyst for use in the deacetalization can be appropriately selected from well-known inorganic acid and organic acids, and examples thereof include inorganic acids such as hydrochloric acid, sulfuric acid, phosphoric acid, hydrobromic acid and hydrofluoric acid, organic acids such as oxalic acid, malonic acid, succinic acid, adipic acid, sebacic acid, citric acid, fumaric acid, maleic acid, formic acid, p-toluenesulfonic acid, methanesulfonic acid, trifluoroacetic acid, dichloroacetic acid, trichloroacetic acid, trifluoromethanesulfonic acid, benzenesulfonic acid, naphthalenesulfonic acid and naphthalenedisulfonic acid, Lewis acids such as zinc chloride, aluminum chloride, iron chloride and boron trifluoride, and solid acids such as tungstosilicic acid, phosphotungstic acid, silicomolybdic acid and phosphomolybdic acid. Among them, sulfuric acid, oxalic acid, citric acid, p-toluenesulfonic acid, methanesulfonic acid, trifluoromethanesulfonic acid, benzenesulfonic acid, naphthalenesulfonic acid, naphthalenedisulfonic acid and phosphotungstic acid are preferable in terms of production.

The deacetalization is preferably performed under ordinary pressure in the presence of the acidic catalyst with water to be used being dropped into the system or sprayed as steam, at a temperature where raw materials used are compatible with each other, or higher (more preferably, 80 to 300°C). The water in the system may be distilled off or refluxed, but it is preferably distilled off together with a low boiling point component generated in the reaction, such as formaldehyde, because an acetal bond can be efficiently removed. The reaction pressure may be ordinary pressure or increased pressure. If necessary, an inert gas such as nitrogen, helium or argon may be allowed to flow into the system.

If necessary, a solvent inert to the deacetalization can also be used. Examples of the solvent include aromatic hydrocarbon-based solvents such as toluene, ethylbenzene and xylene, saturated aliphatic hydrocarbon-based solvents such as heptane and hexane, alicyclic hydrocarbon-based solvents such as cyclohexane, ether-based solvents such as dioxane and dibutyl ether, ketone-based solvents such as methyl isobutyl ketone, carboxylic acid ester-based solvents such as ethyl propionate, and carboxylic acid-based solvents such as acetic acid.

The amount of the acidic catalyst to be used is preferably 0.0001 parts by mass or more and 100 parts by mass or less, more preferably 0.001 parts by mass or more and 85 parts by mass or less, further preferably 0.001 parts by mass or more and 70 parts by mass or less based on 100 parts by mass of the naphthalene formaldehyde resin. Such an amount range tends to enable a proper reaction rate to be achieved, and enable an increase in resin viscosity due

to a high reaction rate to be prevented. The acidic catalyst may also be charged at one time or in portions.

Water for use in the deacetalization is not particularly limited as long as it can be industrially used, and examples thereof include tap water, distilled water, ion-exchange water, pure water and ultrapure water.

The amount of the water to be used is preferably 0.1 parts by mass or more and 10000 parts by mass or less, more preferably 1.0 part by mass or more and 5000 parts by mass or less, further preferably 10 parts by mass or more and 3000 parts by mass or less based on 100 parts by mass of the naphthalene formaldehyde resin.

The reaction time in the deacetalization is preferably 0.5 to 20 hours, more preferably 1 to 15 hours, further preferably 2 to 10 hours. Such a reaction time range tends to allow a resin having objective properties to be economically and industrially obtained.

The reaction temperature in the deacetalization is preferably 80 to 300°C, more preferably 85 to 270°C, further preferably 90 to 240°C. Such a reaction temperature range tends to allow a resin having objective properties to be economically and industrially obtained.

The deacetalized naphthalene formaldehyde resin is decreased in the oxygen concentration and increased in the softening point, as compared with the naphthalene formaldehyde resin. For example, when the deacetalization is performed in an amount of the acidic catalyst to be used of 0.05 parts by mass and an amount of the water to be used of 2000 parts by mass at a reaction temperature of 150°C for a reaction time of 5 hours, the oxygen concentration tends to be lower by about 0.1 to 8.0% by mass and the softening point tends to be higher by about 3 to 100°C.

[Modified naphthalene formaldehyde resin and production method thereof]

The modified naphthalene formaldehyde resin is obtained by heating the naphthalene formaldehyde resin or the deacetalized naphthalene formaldehyde resin, and a hydroxy-substituted aromatic compound represented by, for example, the following formula (2) in the presence of an acidic catalyst, to perform a modification condensation reaction. In the present embodiment, the "modification condensation reaction" is referred to as the "modification".

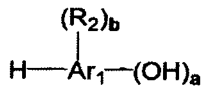

(2)

In the formula (2), $Ar_1$ represents an aromatic ring structure; each $R_2$ independently represents a hydrogen atom, an alkyl group or an aryl group as a monovalent substituent; the position of the substituent of the aromatic ring can be arbitrarily selected; a represents an integer of 1 to 3 as the number of hydroxy group(s) bonded; and b represents, as the number of R bonded, (5-a), (7-a), and (9-a), when $Ar_1$ represents a benzene structure, a naphthalene structure, and a biphenylene structure, respectively.

Examples of the aromatic ring in the formula (2) include a benzene ring, a naphthalene ring and an anthracene ring, but are not particularly limited thereto. In addition, the alkyl group in $R_2$ is preferably a straight or branched alkyl group having 1 to 8 carbon atoms, more preferably a straight or branched alkyl group having 1 to 4 carbon atoms, and specific examples include a methyl group, an ethyl group, a propyl group, an isopropyl group, a butyl group, a sec-butyl group and a tert-butyl group, but are not particularly limited thereto. Furthermore, examples of the aryl group in $R_2$ include a phenyl group, a p-tolyl group, a naphthyl group and an anthryl group, but are not particularly limited thereto.

The hydroxy-substituted aromatic compound represented by the formula (2) is preferably one or more selected from the group consisting of phenol, 2,6-xylenol, naphthol, dihydroxynaphthalene, biphenol, hydroxyanthracene and dihydroxyanthracene.

The amount of the hydroxy-substituted aromatic compound to be used is preferably 0.1 mol or more and 5.0 mol or less, more preferably 0.2 mol or more and 4.0 mol or less, further preferably 0.3 mol or more and 3.0 mol or less based on 1 mol of oxygen contained in the naphthalene formaldehyde resin or the deacetalized naphthalene formaldehyde resin. Such an amount range tends to enable the yield of the resulting modified naphthalene resin to be kept at a relatively high value, and enable the amount of the unreacted remaining hydroxy-substituted aromatic compound to be smaller.

The molecular weight of the resulting resin is affected by the number of moles of oxygen contained in the naphthalene formaldehyde resin or the deacetalized naphthalene formaldehyde resin and the amount of the hydroxy-substituted aromatic compound to be used, and the molecular weight is decreased if both the above number and amount are increased. The number of moles of oxygen contained here can be determined by measuring the oxygen concentration (% by mass) in the naphthalene formaldehyde resin or the deacetalized naphthalene formaldehyde resin by organic element analysis, and performing calculation according to the following calculation expression.

$$\text{Number of moles of oxygen contained (mol)} = \text{Amount of resin used (g)} \times \text{Oxygen concentration (\% by mass)}/16$$

The acidic catalyst for use in the modification reaction can be appropriately selected from well-known inorganic acid and organic acids, and examples thereof include inorganic acids such as hydrochloric acid, sulfuric acid, phosphoric acid, hydrobromic acid and hydrofluoric acid, organic acids such as oxalic acid, malonic acid, succinic acid, adipic acid, sebacic acid, citric acid, fumaric acid, maleic acid, formic acid, p-toluenesulfonic acid, methanesulfonic acid, trifluoroacetic acid, dichloroacetic acid, trichloroacetic acid, trifluoromethanesulfonic acid, benzenesulfonic acid, naphthalenesulfonic acid and naphthalenedisulfonic acid, Lewis acids such as zinc chloride, aluminum chloride, iron chloride and boron trifluoride, and solid acids such as tungstosilicic acid, phosphotungstic acid, silicomolybdic acid and phosphomolybdic acid. Among them, sulfuric acid, oxalic acid, citric acid, p-toluenesulfonic acid, methanesulfonic acid, trifluoromethanesulfonic acid, benzenesulfonic acid, naphthalenesulfonic acid, naphthalenedisulfonic acid and phosphotungstic acid are preferable in terms of production.

The amount of the acidic catalyst to be used is preferably 0.0001 parts by mass or more and 100 parts by mass or less, more preferably 0.001 parts by mass or more and 85 parts by mass or less, further preferably 0.001 parts by mass or more and 70 parts by mass or less based on 100 parts by mass of the naphthalene formaldehyde resin or the deacetalized naphthalene formaldehyde resin. Such an amount range tends to enable a proper reaction rate to be achieved, and enable an increase in resin viscosity due to a high reaction rate to be prevented. The acidic catalyst may also be charged at one time or in portions.

The modification reaction is preferably performed under ordinary pressure in the presence of the acidic catalyst with heating under reflux or with distillation off of water produced, at a temperature where raw materials used are compatible with each other, or higher (more preferably, 80 to 300°C). The reaction pressure may be ordinary pressure or increased pressure. If necessary, an inert gas such as nitrogen, helium or argon may be allowed to flow into the system.

If necessary, a solvent inert to the modification reaction can also be used. Examples of the solvent include aromatic hydrocarbon-based solvents such as toluene, ethylbenzene and xylene; saturated aliphatic hydrocarbon-based solvents such as heptane and hexane; alicyclic hydrocarbon-based solvents such as cyclohexane; ether-based solvents such as dioxane and dibutyl ether; alcohol-based solvents such as 2-propanol; ketone-based solvents such as methyl isobutyl ketone; carboxylic acid ester-based solvents such as ethyl propionate, and carboxylic acid-based solvents such as acetic acid.

The reaction time in the modification reaction is preferably 0.5 to 20 hours, more preferably 1 to 15 hours, further preferably 2 to 10 hours. Such a reaction time range tends to allow a resin having objective properties to be economically and industrially advantageously obtained.

The reaction temperature in the modification reaction is preferably 80 to 300°C, more preferably 85 to 270°C, further preferably 90 to 240°C. Such a reaction temperature range tends to allow a resin having objective properties to be economically and industrially advantageously obtained.

After completion of the reaction, the modified naphthalene formaldehyde resin is obtained by further adding, if necessary, the solvent for dilution, thereafter leaving the resultant to still stand for two-phase separation to thereby separate a resin phase as an oil phase and an aqueous phase, thereafter further performing washing with water to thereby completely remove the acidic catalyst, and removing the solvent added and the unreacted raw materials by a common method such as distillation.

The modified naphthalene formaldehyde resin is increased in the amount of the residue in pyrolysis (reduced in mass loss rate) and is increased in the hydroxyl value, as compared with the naphthalene formaldehyde resin or the deacetalized formaldehyde resin. For example, when the modification is performed in an amount of the acidic catalyst to be used of 0.05 parts by mass at a reaction temperature of 200°C for a reaction time of 5 hours, the amount of the residue in pyrolysis tends to be larger by about 1 to 50% and the hydroxyl value tends to be higher by about 1 to 300.

The modified naphthalene formaldehyde resin obtained by the above production method is not particularly limited, but it can be represented by the following formula (9).

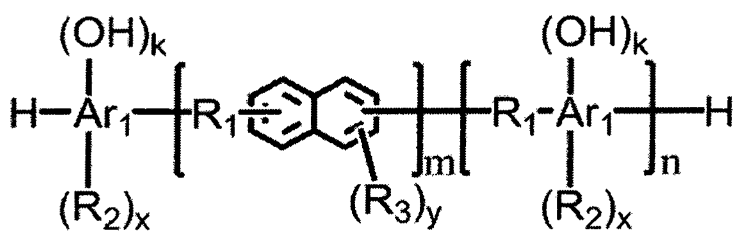

(9)

In formula (9), $Ar_1$ represents an aromatic ring structure, each $R_1$ independently represents a methylene group, a methyleneoxy group, a methyleneoxymethylene group or an oxymethylene group, or a combination thereof; each $R_2$ independently represents a hydrogen atom, an alkyl group or an aryl group as a monovalent substituent, each $R_3$ independently represents an alkyl group having 1 to 3 carbon atoms, an aryl group, a hydroxy group, or a hydroxymethylene group; m represents an integer of 1 or more and n represents an integer of 0 or more, in which cases where m and n each represent a different integer are mixed; k represents an integer of 1 to 3 as the number of hydroxy group(s) bonded; x represents "the number of $Ar_1$ which can be bonded - (k+2)" as the number of $R_2$ bonded, and represents, for example, (4-k), (6-k), and (8-k) when $Ar_1$ represents a benzene structure, a naphthalene structure, and a biphenylene structure, respectively; and each y independently represents an integer of 0 to 4.

In the formula (9), each repeating unit is arranged in any manner. That is, the compound of the formula (9) may be a random copolymer or a block copolymer. Herein, the upper limit of m is preferably 50 or less, more preferably 20 or less, and the upper limit of n is preferably 20 or less.

The main product of the modified naphthalene formaldehyde resin is obtained by converting the formaldehyde to a methylene group in the modification and bonding the aromatic ring(s) of the naphthalene ring and/or the hydroxy-substituted aromatic compound via such a methylene group. Herein, the modified naphthalene formaldehyde resin obtained after the modification is obtained as a mixture of many compounds because the position of the formaldehyde bonded to each of the aromatic rings of the naphthalene ring and the hydroxy-substituted aromatic compound, the position of the hydroxy group bonded, the degree of polymerization, and the like are not constant.

The OH value of the modified naphthalene formaldehyde resin is preferably 140 to 560 mgKOH/g, more preferably 160 to 470 mgKOH/g in terms of solvent solubility. Herein, the OH value is determined based on JIS-K1557-1.

[Cyanic acid ester compound and production method thereof]

A cyanic acid ester compound in the present embodiment is obtained by cyanation of the hydroxy group included in the modified naphthalene formaldehyde resin. The cyanation method is not particularly limited, and a known method can be applied. Specifically, the cyanic acid ester compound in the present embodiment can be obtained by: a method in which the modified naphthalene formaldehyde resin and cyanogen halide are reacted in a solvent in the presence of a basic compound; a method in which a modified naphthalene formaldehyde resin and cyanogen halide are reacted in a solvent in the presence of a base with the cyanogen halide being constantly present more excessively than the base (U.S. Patent No. 3553244); a method in which, while tertiary amine is used as a base and is more excessively used than cyanogen halide, the tertiary amine is added and thereafter the cyanogen halide is dropped, or the cyanogen halide and the tertiary amine are simultaneously injected and dropped to a modified naphthalene formaldehyde resin in the presence of a solvent (Japanese Patent No. 3319061); a method in which a modified naphthalene formaldehyde resin, a trialkylamine and cyanogen halide are reacted in a continuous plug flow system (Japanese Patent No. 3905559); a method in which tert-ammonium halide obtained as a by-product in a reaction of a modified naphthalene formaldehyde resin and cyanogen halide in a non-aqueous solution in the presence of tert-amine is treated with a pair of cation and anion (Japanese Patent No. 4055210); a method in which a modified naphthalene formaldehyde resin is reacted with tertiary amine and cyanogen halide simultaneously added, in the presence of a solvent that can be separated from water, thereafter the resultant is washed with water for liquid separation, and a reaction product is precipitated in and purified from the resulting solution by using a poor solvent such as secondary or tertiary alcohols, or hydrocarbons (Japanese Patent No. 2991054); a method in which naphthols, cyanogen halide and tertiary amine are reacted in a binary phase solvent of water and an organic solvent under an acidic condition (Japanese Patent No. 5026727); or the like.

When the method in which the modified naphthalene formaldehyde resin and the cyanogen halide are reacted in a solvent in the presence of a basic compound is used, the modified naphthalene formaldehyde resin as a reactant is dissolved in either a cyanogen halide solution or a basic compound solution in advance and thereafter the cyanogen halide solution and the basic compound solution are brought into contact with each other. Examples of the method for bringing the cyanogen halide solution and the basic compound solution into contact with each other include, but not limited, (A) a method in which the basic compound solution is injected into the cyanogen halide solution stirred and mixed, (B) a method in which the cyanogen halide solution is injected into the basic compound solution stirred and mixed, and (C) a method in which the cyanogen halide solution and the basic compound solution are fed continuously alternately or simultaneously.

Among the methods (A) to (C), the method (A) is preferably performed because a side reaction can be suppressed to allow a higher-purity cyanic acid ester compound to be obtained at a high yield.

In addition, the method for bringing the cyanogen halide solution and the basic compound solution into contact with each other can be performed in any of a semi-batch system or a continuous flow system.

In particular, when the method (A) is used, the basic compound is preferably injected in divisions from the viewpoints that the reaction can be completed without any remaining hydroxy group of the modified naphthalene formaldehyde resin and a higher-purity cyanic acid ester compound can be obtained at a high yield. The number of divisions

is not particularly limited and is preferably 1 to 5. In addition, the type of the basic compound may be the same or different with respect to every division.

Examples of the cyanogen halide in the present embodiment include cyanogen chloride and cyanogen bromide. As the cyanogen halide, cyanogen halide obtained by a known production method such as a method for reacting hydrogen cyanide or metal cyanide with halogen may be used, or a commercially available product may be used.
In addition, a reaction solution containing cyanogen halide obtained by the reaction of hydrogen cyanide or metal cyanide with halogen can also be used as it is.

The amount of the cyanogen halide to be used in the cyanation step based on the modified naphthalene formaldehyde resin is preferably 0.5 mol or more and 5.0 mol or less, more preferably 1.0 mol or more and 3.5 mol or less based on 1 mol of the hydroxy group of the modified naphthalene formaldehyde resin. The reason for this is because no unreacted modified naphthalene formaldehyde resin remains and the yield of the cyanic acid ester compound is increased.

The solvent for use in the cyanogen halide solution is not particularly limited, and can be any of ketone-based solvents such as acetone, methyl ethyl ketone and methyl isobutyl ketone; aliphatic solvents such as n-hexane, cyclohexane, isooctane, cyclohexanone, cyclopentanone and 2-butanone; aromatic solvents such as benzene, toluene and xylene; ether-based solvents such as diethyl ether, dimethyl cellosolve, diglyme, tetrahydrofuran, methyltetrahydrofuran, dioxane and tetraethylene glycol dimethyl ether; halogenated hydrocarbon-based solvents such as dichloromethane, chloroform, carbon tetrachloride, dichloroethane, trichloroethane, chlorobenzene and bromobenzene; alcohol-based solvents such as methanol, ethanol, isopropanol, methyl cellosolve and propylene glycol monomethyl ether; aprotic polar solvents such as N,N-dimethylformamide, N-methylpyrrolidone, 1,3-dimethyl-2-imidazolidone and dimethyl sulfoxide; nitrile-based solvents such as acetonitrile and benzonitrile; nitro-based solvents such as nitromethane and nitrobenzene; ester-based solvents such as ethyl acetate and ethyl benzoate; hydrocarbon-based solvents such as cyclohexane; a water solvent; and the like. Such solvents can be used singly or in combinations of two or more thereof depending on the reactant.

The basic compound for use in the cyanation step can be any of an organic base and an inorganic base.

The organic base is preferably any tertiary amine such as trimethylamine, triethylamine, tri-n-butylamine, triamylamine, diisopropylethylamine, diethyl-n-butylamine, methyl di-n-butylamine, methylethyl-n-butylamine, dodecyldimethylamine, tribenzylamine, triethanolamine, N,N-dimethylaniline, N,N-diethylaniline, diphenylmethylamine, pyridine, diethylcyclohexylamine, tricyclohexylamine, 1,4-diazabicyclo[2.2.2]octane, 1,8-diazabicyclo[5.4.0]-7-undecene and 1,5-diazabicyclo[4.3.0]-5-nonene. Among them, trimethylamine, triethylamine, tri-n-butylamine and diisopropylethylamine are more preferable, and triethylamine is further preferable because of providing the intended product at a good yield.

The amount of the organic base to be used is preferably 0.1 mol or more and 8.0 mol or less, more preferably 1.0 mol or more and 3.5 mol or less based on 1 mol of the hydroxy group of the phenol resin. The reason for this is because no unreacted modified naphthalene formaldehyde resin remains and the yield of the cyanic acid ester compound is increased.

The inorganic base is preferably an alkali metal hydroxide. Examples of the alkali metal hydroxide include, but not particularly limited, sodium hydroxide, potassium hydroxide and lithium hydroxide industrially commonly used. Sodium hydroxide is more preferable because of being inexpensively available.

The amount of the inorganic base to be used is preferably 1.0 mol or more and 5.0 mol or less, more preferably 1.0 mol or more and 3.5 mol or less based on 1 mol of the hydroxy group of the modified naphthalene formaldehyde resin. The reason for this is because no unreacted modified naphthalene formaldehyde resin remains and the yield of the cyanic acid ester compound is increased.

In the present reaction, the basic compound can be used as a solution thereof in a solvent, as described above. As the solvent, an organic solvent or water can be used.

When the modified naphthalene formaldehyde resin is dissolved in the basic compound solution, the amount of the solvent for use in the basic compound solution is preferably 0.1 parts by mass or more and 100 parts by mass, more preferably 0.5 parts by mass or more and 50 parts by mass or less based on 1 part by mass of the modified naphthalene formaldehyde resin. When the modified naphthalene formaldehyde resin is not dissolved in the basic compound solution, the amount of the solvent is preferably 0.1 parts by mass or more and 100 parts by mass, more preferably 0.25 parts by mass or more and 50 parts by mass or less based on 1 part by mass of the basic compound.

An organic solvent for dissolving the basic compound is preferably used when the basic compound is the organic base, and the organic solvent can be appropriately selected from the following: ketone-based solvents such as acetone, methyl ethyl ketone and methyl isobutyl ketone; aromatic solvents such as benzene, toluene and xylene; ether-based solvents such as diethyl ether, dimethyl cellosolve, diglyme, tetrahydrofuran, methyltetrahydrofuran, dioxane and tetraethylene glycol dimethyl ether; halogenated hydrocarbon-based solvents such as dichloromethane, chloroform, carbon tetrachloride, dichloroethane, trichloroethane, chlorobenzene and bromobenzene; alcohol-based solvents such as methanol, ethanol, isopropanol, methyl cellosolve and propylene glycol monomethyl ether; aprotic polar solvents such as N,N-dimethylformamide, N-methylpyrrolidone, 1,3-dimethyl-2-imidazolidone and dimethyl sulfoxide; nitrile-based solvents such as acetonitrile and benzonitrile; nitro-based solvents such as nitromethane and nitrobenzene; ester-based solvents such as ethyl acetate and ethyl benzoate; hydrocarbon-based solvents such as cyclohexane; depending on the basic compound, the reactant, and the solvent for use in the reaction. Such solvents can be used singly or in combinations of two or more thereof.

Water for dissolving the basic compound is preferably used when the basic compound is the inorganic base, and such water may be tap water, distilled water or deionized water without particular limitation. Distilled water or deionized water having few impurities is preferably used in order that the intended cyanic acid ester compound is efficiently obtained.

When the solvent for use in the basic compound solution is water, a catalytic amount of the organic base is preferably used as a surfactant from the viewpoint that the reaction rate is ensured. In particular, a tertiary amine less causing a side reaction is preferable. Examples of the tertiary amine include, but not particularly limited to any of alkylamine, arylamine and cycloalkylamine, and specific examples thereof include trimethylamine, triethylamine, tri-n-butylamine, triamylamine, diisopropylethylamine, diethyl-n-butylamine, methyl di-n-butylamine, methylethyl-n-butylamine, dodecyldimethylamine, tribenzylamine, triethanolamine, N,N-dimethylaniline, N,N-diethylaniline, diphenylmethylamine, pyridine, diethylcyclohexylamine, tricyclohexylamine, 1,4-diazabicyclo[2.2.2]octane, 1,8-diazabicyclo[5.4.0]-7-undecene and 1,5-diazabicyclo[4.3.0]-5-nonene. Among them, trimethylamine, triethylamine, tri-n-butylamine and diisopropylethylamine are more preferable, and triethylamine is further preferable because of being high in solubility in water and providing the intended product at a good yield.

The amount of the entire solvent for use in the cyanation step is preferably 2.5 parts by mass or more and 100 parts by mass or less based on 1 part by mass of the modified naphthalene formaldehyde resin from the viewpoint that the modified naphthalene formaldehyde resin is uniformly dissolved to allow the cyanic acid ester compound to be efficiently produced.

In the cyanation step, the pH of the reaction solution is not particularly limited, but the reaction is preferably performed with the pH being kept at less than 7. The reason for this is because the pH can be suppressed at less than 7 to thereby inhibit by-products such as imide carbonate and a polymer of the cyanic acid ester compound from being produced and therefore the cyanic acid ester compound tends to be efficiently produced. A method of adding an acid is preferable for keeping the pH of the reaction solution at less than 7, and it is preferable in such a method that an acid be added to the cyanogen halide solution immediately before the cyanation step or an acid be added to the reaction system with the pH being appropriately measured by a pH meter during the reaction so that the pH is kept at less than 7. Examples of the acid used here include inorganic acids such as hydrochloric acid, nitric acid, sulfuric acid and phosphoric acid; and organic acids such as acetic acid, lactic acid and propionic acid.

The reaction temperature in the cyanation step is preferably -20 to +50°C, more preferably -15 to 15°C, further preferably -10 to 10°C from the viewpoints that by-products such as imide carbonate, a polymer of the cyanic acid ester compound, and dialkyl cyanamide are inhibited from being produced, that the reaction solution is inhibited from being condensed, and that, when cyanogen chloride is used as the cyanogen halide, the cyanogen chloride is inhibited from being volatilized.

The reaction pressure in the cyanation step may be ordinary pressure or increased pressure. If necessary, an inert gas such as nitrogen, helium or argon may be allowed to flow into the system.

In addition, the reaction time is not particularly limited, but the injection time in the case of any of the methods (A) and (B) as the contact method, and the contact time in the case of the method (C) as the contact method are preferably 1 minute to 20 hours, more preferably 3 minutes to 10 hours. Thereafter, stirring is preferably conducted for additional 10 minutes to 10 hours with the reaction temperature being kept. Such a reaction time range tends to allow the intended cyanic acid ester compound to be more economically and industrially advantageously obtained.

The degree of progress of the reaction in the cyanation step can be analyzed by liquid chromatography, an IR spectrum method or the like. Volatile components such as dicyanogen and dialkyl cyanamide as by-products can be analyzed by gas chromatography.

After completion of the reaction, a usual posttreatment operation, and, if desired, a separation/purification operation can be performed to thereby isolate the intended cyanic acid ester compound. Specifically, an organic solvent layer including the cyanic acid ester compound may be separated from the reaction solution, and washed with water and thereafter subjected to concentration, precipitation or crystallization, or washed with water and thereafter subjected to solvent replacement. In washing, in order to remove excessive amines, a method in which an acidic aqueous solution such as dilute hydrochloric acid is used is also adopted. In order to remove the water content from the reaction solution sufficiently washed, a drying operation can be performed by a common method using sodium sulfate, magnesium sulfate or the like. In concentration and solvent replacement, in order to suppress polymerization of the cyanic acid ester compound, the organic solvent is distilled off with heating to a temperature of 90°C or lower under reduced pressure. In precipitation or crystallization, a solvent low in solubility can be used. For example, a method can be adopted in which an ether-based solvent, a hydrocarbon-based solvent such as hexane, or an alcohol-based solvent is dropped or reversely injected to the reaction solution. In order to wash the resulting crude product, a method can be adopted in which a

concentrate or a crystal precipitated of the reaction solution is washed with an ether-based solvent, a hydrocarbon-based solvent such as hexane, or an alcohol-based solvent. The reaction solution can be concentrated to provide a crystal, and the crystal can be dissolved again and re-crystallized. In addition, when crystallization is performed, the reaction solution may be simply concentrated or cooled. The purification method of the resulting cyanic acid ester compound will be described later in detail.

The cyanic acid ester compound obtained by the above production method is not particularly limited, but it can be represented by the following formula (1).

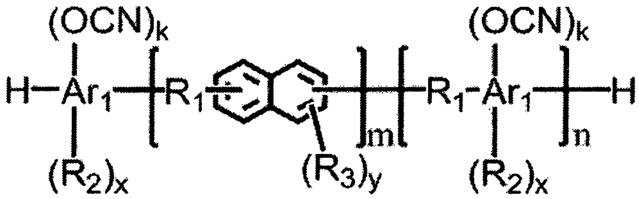

(1)

In formula (1), $Ar_1$ represents an aromatic ring structure, each $R_1$ independently represents a methylene group, a methyleneoxy group, a methyleneoxymethylene group or an oxymethylene group, or a combination thereof; each $R_2$ independently represents a hydrogen atom, an alkyl group or an aryl group as a monovalent substituent, each $R_3$ independently represents an alkyl group having 1 to 3 carbon atoms, an aryl group, a hydroxy group, or a hydroxymethylene group, m represents an integer of 1 or more and n represents an integer of 0 or more, in which compounds where m and n each represent a different integer are mixed; each repeating unit is arranged in any manner; k represents an integer of 1 to 3 as the number of cyanato group(s) bonded; x represents an integer of "the number of $Ar_1$ which can be bonded - (k+2)" as the number of $R_2$ bonded, and represents, for example, (4-k), (6-k), and (8-k) when $Ar_1$ represents a benzene structure, a naphthalene structure, and a biphenylene structure, respectively; and each y independently represents an integer of 0 to 4.

In the formula (1), each repeating unit is arranged in any manner, and the compound represented by the formula (1) may be a random copolymer or a block copolymer. Herein, the upper limit of m is preferably 50 or less, more preferably 20 or less, and the upper limit of n is preferably 20 or less.

For example, a cyanic acid ester compound obtained by reacting a naphthol-modified naphthalene formaldehyde resin and cyanogen halide in a solvent in the presence of a basic compound, in Synthesis Example 1 described later, is a cyanic acid ester mixture whose representative composition includes a compound group represented by the following formula (10).

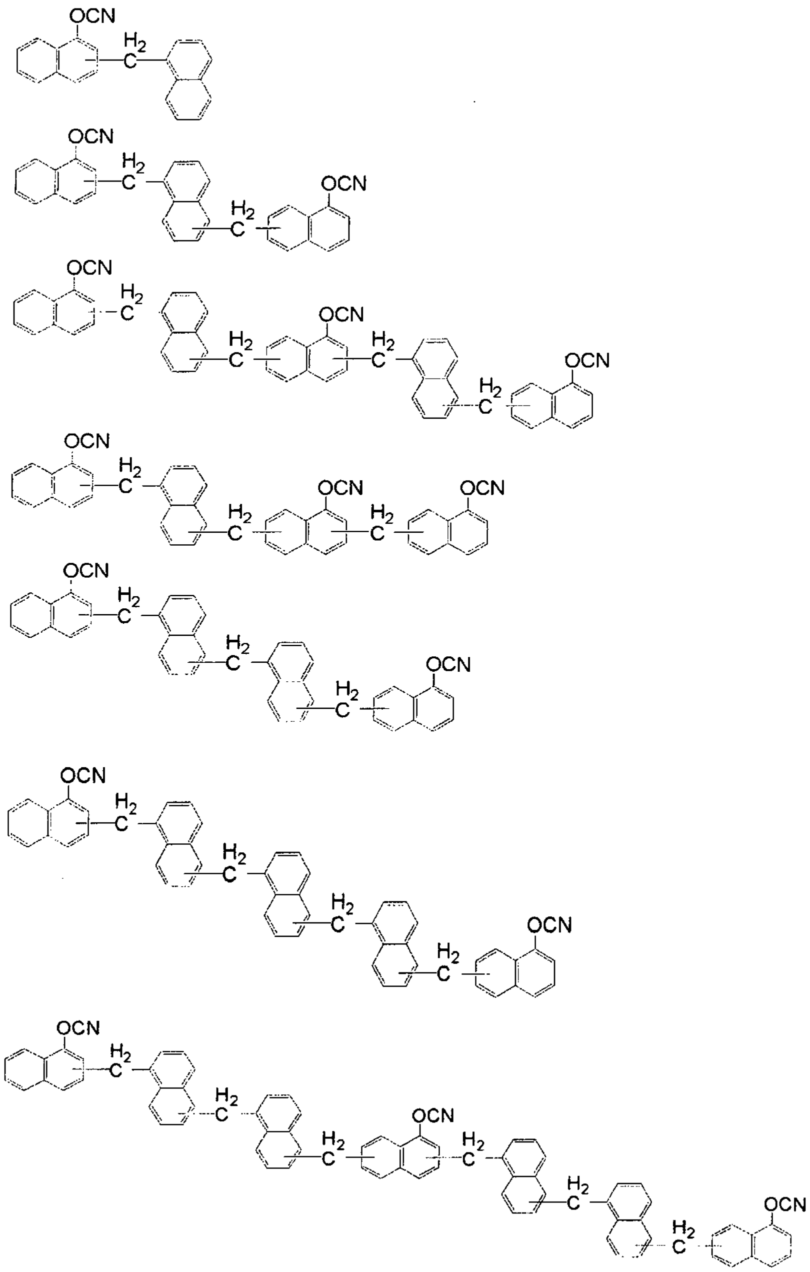

(1 0)

The weight average molecular weight (Mw) of the cyanic acid ester compound in the present embodiment is not particularly limited, but it is preferably 200 or more and 25000 or less, more preferably 250 or more and 20000 or less, further preferably 300 or more and 15000 or less.

The resulting cyanic acid ester compound can be identified by a known method such as NMR. The purity of the cyanic acid ester compound can be analyzed by liquid chromatography, an IR spectrum method or the like. The amounts of volatile components, for example, by-products such as dialkyl cyanamide in the cyanic acid ester compound, and the remaining solvent can be quantitatively analyzed by gas chromatography. The halogen compound remaining in the cyanic acid ester compound can be identified by a liquid chromatograph mass spectrometer, and the amount thereof can be quantitatively analyzed by potentiometric titration with a silver nitrate solution or by ion chromatography after decomposition by a combustion method. The polymerization reactivity of the cyanic acid ester compound can be evaluated based on the gelation time by a hot plate method or a torque measuring method.

[Purification method of cyanic acid ester compound]

The cyanic acid ester compound may be if necessary further purified in order to further enhance purity and reduce the amount of the remaining metal. In addition, an acid catalyst and a co-catalyst remain to thereby generally

deteriorate storage stability of a composition for forming an underlayer film, or a basic catalyst remains to thereby generally deteriorate sensitivity of a composition for forming an underlayer film, and therefore purification for the purpose of reductions in the amounts of such remaining catalysts may be performed.

Such purification can be performed by a known method as long as the cyanic acid ester compound is not modified, and examples include, but not particularly limited, a method of washing with water, a method of washing with an acidic aqueous solution, a method of washing with a basic aqueous solution, a method of treating with an ion exchange resin, and a method of treating with silica gel column chromatography. These purification methods may be performed singly, but are preferably performed in combinations of two or more. The purification method of washing with an acidic aqueous solution will be described later in detail.

The acidic aqueous solution, the basic aqueous solution, the ion exchange resin and the silica gel column chromatography can be appropriately selected optimally depending on the metal to be removed, the amount(s) and the type(s) of an acidic compound and/or a basic compound, the type of the cyanic acid ester compound to be purified, and the like. Examples of the acidic aqueous solution include an aqueous solution of hydrochloric acid, nitric acid or acetic acid, having a concentration of 0.01 to 10 mol/L, examples of the basic aqueous solution include an aqueous ammonia solution having a concentration of 0.01 to 10 mol/L, and examples of the ion exchange resin include a cation exchange resin (for example, Amberlyst 15J-HG Dry produced by Organo Corporation).

Drying may also be performed after the above purification. Such drying can be performed by a known method, and examples thereof include, but are not particularly limited, a vacuum drying method or a hot air drying method in a condition where the cyanic acid ester compound is not modified.

[Purification method by washing with acidic aqueous solution]

The purification method of the cyanic acid ester compound by washing with an acidic aqueous solution is, for example, as follows. The method includes a step of dissolving the cyanic acid ester compound in an organic solvent optionally immiscible with water, bringing the solution into contact with an acidic aqueous solution for performing an extraction treatment, to thereby transfer the cyanic acid ester compound and a metal content included in the solution (B) including the organic solvent to an aqueous phase, and then separating an organic phase and the aqueous phase. The purification can allow the contents of various metals in the composition for forming an underlayer film for lithography of the present embodiment to be remarkably reduced.

The organic solvent optionally immiscible with water is not particularly limited, but it is preferably an organic solvent that can be safely applied to a semiconductor manufacturing process. The amount of the organic solvent to be used is preferably 1.0 time by mass or more and 100 times by mass or less the amount of the cyanic acid ester compound to be used.

Specific examples of the organic solvent to be used include, for example, ethers such as diethyl ether and diisopropyl ether, esters such as ethyl acetate, n-butyl acetate and isoamyl acetate; ketones such as methyl ethyl ketone, methyl isobutyl ketone, ethyl isobutyl ketone, cyclohexanone, cyclopentanone, 2-heptanone and 2-pentanone; glycol ether acetates such as ethylene glycol monoethyl ether acetate, ethylene glycol monobutyl ether acetate, propylene glycol monomethyl ether acetate (PGMEA) and propylene glycol monoethyl ether acetate; aliphatic hydrocarbons such as n-hexane and n-heptane; aromatic hydrocarbons such as toluene and xylene; and halogenated hydrocarbons such as methylene chloride and chloroform. Among them, toluene, 2-heptanone, cyclohexanone, cyclopentanone, methyl isobutyl ketone, propylene glycol monomethyl ether acetate, and ethyl acetate are preferable, and cyclohexanone and propylene glycol monomethyl ether acetate are more preferable. These organic solvents can be used singly or as a mixture of two or more thereof.

The acidic aqueous solution is appropriately selected from aqueous solutions in which an organic or inorganic compound commonly known is dissolved in water. Examples include an aqueous solution in which a mineral acid such as hydrochloric acid, sulfuric acid, nitric acid or phosphoric acid is dissolved in water, or an aqueous solution in which an organic acid such as acetic acid, propionic acid, oxalic acid, malonic acid, succinic acid, fumaric acid, maleic acid, tartaric acid, citric acid, methanesulfonic acid, phenolsulfonic acid, p-toluenesulfonic acid or trifluoroacetic acid is dissolved in water. These acidic aqueous solutions can be used singly or in combinations of two or more thereof. Among these acidic aqueous solutions, an aqueous solution of sulfuric acid, nitric acid, or a carboxylic acid such as acetic acid, oxalic acid, tartaric acid or citric acid is preferable, further, an aqueous solution of sulfuric acid, oxalic acid, tartaric acid or citric acid is preferable, and particularly, an aqueous solution of oxalic acid is preferable. It is considered that a polyvalent carboxylic acid such as oxalic acid, tartaric acid and citric acid is coordinated with a metal ion to exert a chelating effect, and therefore can allow a metal to be more removed. In addition, the water to be here used is preferably water having a low metal content according to the object of the present invention, and, for example, ion-exchange water is preferable.

The pH of the acidic aqueous solution is not particularly limited, but a too high acidity of the aqueous solution is not preferable because of sometimes having an adverse effect on the compound or resin to be used. The pH is

preferably in the range from about 0 to 5, more preferably about 0 to 3.

The amount of the acidic aqueous solution to be used is not particularly limited, but, when the amount is too small, the number of extractions for metal removal is required to be larger, and on the contrary, when the amount of the aqueous solution is too large, the total amount of the liquid is larger to cause the problem of handling in some cases. The amount of the aqueous solution to be used is preferably 10% by mass or more and 200% by mass or less, more preferably 20 to 100% by mass based on the solution (100% by mass) of the cyanic acid ester compound.

The acidic aqueous solution is brought into contact with the solution (B) including the cyanic acid ester compound and the organic solvent optionally immiscible with water to thereby extract the metal content.

The temperature in performing of the extraction treatment is preferably in the range from 20 to 90°C, more preferably in the range from 30 to 80°C. The extraction operation is performed by, for example, well mixing with stirring or the like and thereafter standing. Thus, the metal content included in the solution including the compound to be used and the organic solvent is transferred to the aqueous phase. In addition, the operation tends to enable the acidity of the solution to be reduced, suppressing the change of properties of the compound to be used.

After the extraction treatment, separation to the solution phase including the compound to be used and the organic solvent, and the aqueous phase is performed and the solution including the organic solvent is recovered by decantation or the like. The standing time is not particularly limited, but, a too short standing time is not preferable because of causing poor separation to the solution phase including the organic solvent, and the aqueous phase. The standing time is usually 1 minute or more, more preferably 10 minutes or more, further preferably 30 minutes or more. In addition, the extraction treatment may be performed only once, but is also effectively performed with operations such as mixing, standing and separation being repeatedly performed multiple times.

When such an extraction treatment is performed by using the acidic aqueous solution, the solution including the organic solvent extracted and recovered from the aqueous solution after the treatment is preferably further subjected to the extraction treatment with water. Such an extraction operation is performed by well mixing with stirring or the like and thereafter standing. The resulting solution is separated to the solution phase including the compound and the organic solvent, and the aqueous phase, and therefore the solution phase is recovered by decantation or the like. In addition, the water to be here used is preferably water having a low metal content according to the object of the present invention, such as ion-exchange water. The extraction treatment may be performed only once, but is also effectively performed with operations such as mixing, standing and separation being repeatedly performed multiple times. In addition, conditions in the extraction treatment, such as the ratio of both to be used, the temperature and the time, are not particularly limited, but may be the same as in the case of the contact treatment with the acidic aqueous solution above.

The water content that can be incorporated in the solution thus obtained, including the compound and the organic solvent, can be easily removed by performing an operation such as distillation under reduced pressure. In addition, an organic solvent can be if necessary added to adjust the concentration of the compound to any concentration.

The method of obtaining only the compound from the resulting solution including the organic solvent can be performed by a known method such as removal under reduced pressure, separation by reprecipitation and a combination thereof. If necessary, a known treatment such as a concentration operation, a filtration operation, a centrifugation operation and a drying operation can be performed.

[Material for forming underlayer film for lithography]

The material for forming an underlayer film for lithography of the present embodiment includes the cyanic acid ester compound obtained by cyanation of the modified naphthalene formaldehyde resin. The material for forming an underlayer film for lithography of the present embodiment may include any cyanic acid ester compound other than the cyanic acid ester compound, a known material for forming an underlayer film for lithography, and the like as long as the intended properties are not impaired.

The content of the cyanic acid ester compound in the material for forming an underlayer film for lithography of the present embodiment is preferably 50% by mass or more and 100% by mass or less, more preferably 70% by mass or more and 100% by mass or less, further preferably 90% by mass or more and 100% by mass or less based on the total amount (100% by mass) of the material for forming an underlayer film, in terms of heat resistance and etching resistance. In addition, the content of the cyanic acid ester compound in the material for forming an underlayer film for lithography of the present embodiment is still more preferably 100% by mass because low heat weight loss is achieved.

The cyanic acid ester compound in the present embodiment is preferably a compound represented by the following formula (1).

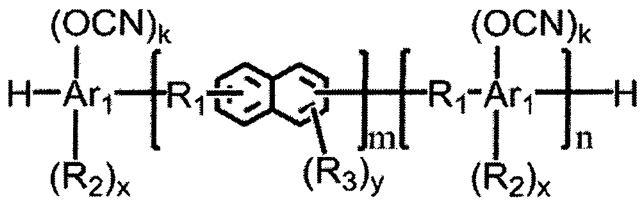

(1)

In formula (1), $Ar_1$, $R_1$, $R_2$, $R_3$, k, m, n, x and y are the same as those described above.

The cyanic acid ester compound in the present embodiment is preferably one wherein $Ar_1$ in the formula (1) represents a naphthalene structure, namely, is preferably a compound represented by the following formula (1-1), in terms of etching resistance and raw material availability.

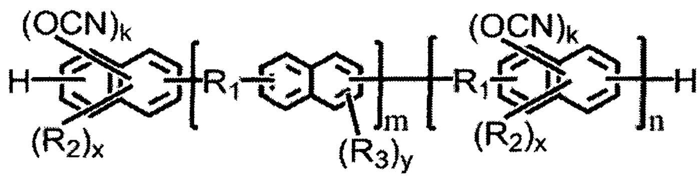

(1 − 1)

In formula (1-1), $R_1$ to $R_3$, k, m, n and y are the same as those described in the formula (1), and x represents an integer of (6-k).

The compound represented by the formula (1-1) is preferably a compound represented by the following formula (1-2) in terms of raw material availability.

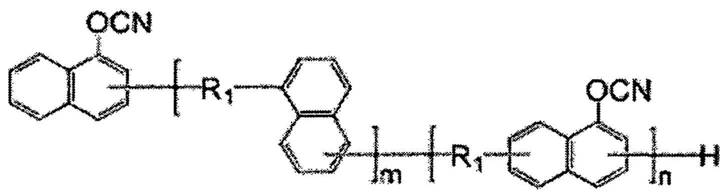

(1 − 2)

In the formula (1-2), $R_1$, m and n are the same as those described in the formula (1).

[Composition for forming underlayer film for lithography]

The composition for forming an underlayer film for lithography of the present embodiment contains the material for forming an underlayer film for lithography, including the cyanic acid ester compound, and a solvent.

[Solvent]

As the solvent for use in the composition for forming an underlayer film for lithography of the present embodiment, a known solvent can be appropriately used as long as it dissolves at least the cyanic acid ester compound. Specific examples of the solvent include, for example, ketone-based solvents such as acetone, methyl ethyl ketone, methyl isobutyl ketone and cyclohexanone; cellosolve-based solvents such as propylene glycol monomethyl ether and propylene glycol monomethyl ether acetate; ester-based solvents such as ethyl lactate, methyl acetate, butyl acetate, isoamyl acetate, ethyl lactate, methyl methoxypropionate and methyl hydroxyisobutyrate; alcohol-based solvents such as methanol, ethanol, isopropanol and 1-ethoxy-2-propanol; and aromatic hydrocarbons such as toluene, xylene and anisole, but are not particularly limited thereto. These solvents can be used singly or in combinations of two or more thereof.

Among the solvents, particularly preferable are cyclohexanone, propylene glycol monomethyl ether, propylene glycol monomethyl ether acetate, ethyl lactate, methyl hydroxyisobutyrate, and anisole, in terms of safety.

When the solvent is contained, the content of the solvent is not particularly limited, but it is preferably 25 parts by mass or more and 9900 parts by mass or less, more preferably 900 parts by mass or more and 4,900 parts by mass or less based on 100 parts by mass of the material for forming an underlayer film, including the cyanic acid ester compound, in terms of solubility and film formation.

The composition for forming an underlayer film for lithography of the present embodiment may contain, if necessary, an acid generator, a crosslinking agent and other component, other than the cyanic acid ester compound

and the solvent. Hereinafter, these optional components will be described.

The composition for forming an underlayer film for lithography of the present embodiment may further contain, if necessary, a crosslinking agent from the viewpoint of suppression of intermixing, and the like. Specific examples of the crosslinking agent usable in the present embodiment include a melamine compound, a guanamine compound, a glycoluril compound, a urea compound, an epoxy compound, a thioepoxy compound, an isocyanate compound, an azide compound, and a compound including a double bond such as an alkenyl ether group, these compounds being substituted with at least one group selected from a methylol group, an alkoxymethyl group and an acyloxymethyl group, as a substituent (crosslinkable group), but are not particularly limited thereto. Herein, these crosslinking agents can be used singly or in combinations of two or more thereof. Such a crosslinking agent can also be used as an additive. Herein, the crosslinkable group may also be introduced as a pendant group into the compound represented by the formula (1). A compound including a hydroxy group can also be used as the crosslinking agent.

Specific examples of the melamine compound include, for example, hexamethylolmelamine, hexamethoxymethylmelamine, a compound in which 1 to 6 methylol groups in hexamethylolmelamine are methoxymethylated, or mixtures thereof, hexamethoxyethylmelamine, hexaacyloxymethylmelamine, and a compound in which 1 to 6 methylol groups in hexamethylolmelamine are acyloxymethylated, or mixtures thereof. Specific examples of the epoxy compound include, for example, tris(2,3-epoxypropyl)isocyanurate, trimethylolmethane triglycidyl ether, trimethylolpropane triglycidyl ether, and triethylolethane triglycidyl ether.

Specific examples of the guanamine compound include, for example, tetramethylolguanamine, tetramethoxymethylguanamine, a compound in which 1 to 4 methylol groups in tetramethylolguanamine are methoxymethylated, or mixtures thereof, tetramethoxyethylguanamine, tetraacyloxyguanamine, and a compound in which 1 to 4 methylol groups in tetramethylolguanamine are acyloxymethylated, or mixtures thereof. Specific examples of the glycoluril compound include, for example, tetramethylolglycoluril, tetramethoxyglycoluril, tetramethoxymethylglycoluril, a compound in which 1 to 4 methylol groups in tetramethylolglycoluril are methoxymethylated, or mixtures thereof, and a compound in which 1 to 4 methylol groups in tetramethylolglycoluril are acyloxymethylated, or mixtures thereof. Specific examples of the urea compound include, for example, tetramethylolurea, tetramethoxymethylurea, a compound in which 1 to 4 methylol groups in tetramethylolurea are methoxymethylated, or mixtures thereof, and tetramethoxyethylurea.

Specific examples of the compound including an alkenyl ether group include, for example, ethylene glycol divinyl ether, triethylene glycol divinyl ether, 1,2-propanediol divinyl ether, 1,4-butanediol divinyl ether, tetramethylene glycol divinyl ether, neopentyl glycol divinyl ether, trimethylolpropane trivinyl ether, hexanediol divinyl ether, 1,4-cyclohexanediol divinyl ether, pentaerythritol trivinyl ether, pentaerythritol tetravinyl ether, sorbitol tetravinyl ether, sorbitol pentavinyl ether, and trimethylolpropane trivinyl ether.

In the composition for forming an underlayer film for lithography of the present embodiment, the content of the crosslinking agent is not particularly limited, but the content is preferably 0.0 parts by mass or more and 50 parts by mass or less, more preferably 0.0 parts by mass or more and 40 parts by mass or less based on 100 parts by mass of the cyanic acid ester compound. The content is set within the above preferable range to result in tendencies to suppress the occurrence of the mixing phenomenon with the resist layer, and to result in tendencies to enhance an antireflective effect and improve film formability after crosslinking.

The composition for forming an underlayer film for lithography of the present embodiment may further contain, if necessary, an acid generator from the viewpoint of further promoting a crosslinking reaction by heat, and the like. As the acid generator, one for generating an acid by pyrolysis and one for generating an acid by light irradiation are known, and any of them can be used.

Examples of the acid generator includes:

1) an onium salt represented by the following general formula (P1a-1), (P1a-2), (P1a-3) or (P1b),
2) a diazomethane derivative represented by the following general formula (P2),
3) a glyoxime derivative represented by the following general formula (P3),
4) a bissulfone derivative represented by the following general formula (P4),
5) a sulfonic acid ester of an N-hydroxyimide compound represented by the following general formula (P5),
6) a β-ketosulfonic acid derivative,
7) a disulfone derivative,
8) a nitrobenzylsulfonate derivative, and
9) a sulfonic acid ester derivative, but are not particularly limited thereto. Herein, these acid generators can be used alone, or two or more thereof can be used in combination.

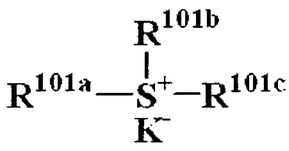
(P1a-1)

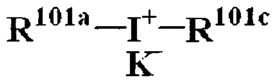
(P1a-2)

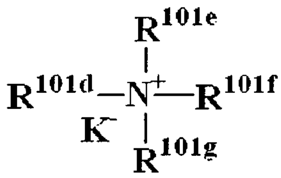
(P1a-3)

In the formulae, each of $R^{101a}$, $R^{101b}$ and $R^{101c}$ independently represents a straight, branched or cyclic alkyl group, alkenyl group, oxoalkyl group or oxoalkenyl group having 1 to 12 carbon atoms; an aryl group having 6 to 20 carbon atoms; or an aralkyl group or aryloxoalkyl group having 7 to 12 carbon atoms, and a part or all of hydrogen atoms of these groups may be substituted with an alkoxy group or the like. In addition, $R^{101b}$ and $R^{101c}$ may form a ring, and if forming a ring, each of $R^{101b}$ and $R^{101c}$ independently represents an alkylene group having 1 to 6 carbon atoms. $K^-$ represents a non-nucleophilic counter ion. Each of $R^{101d}$, $R^{101e}$, $R^{101f}$ and $R^{101g}$ are represented by each independently adding a hydrogen atom to $R^{101a}$, $R^{101b}$ and $R^{101c}$. $R^{101d}$ and $R^{101e}$, and $R^{101d}$, $R^{101e}$ and $R^{101f}$ may form a ring, and if forming a ring, $R^{101d}$ and $R^{101e}$, and $R^{101d}$, $R^{101e}$ and $R^{101f}$ represent an alkylene group having 3 to 10 carbon atoms, or represent a heteroaromatic ring having therein the nitrogen atom(s) in the formula.

$R^{101a}$, $R^{101b}$, $R^{101}$, $R^{101d}$, $R^{101e}$, $R^{101f}$ and $R^{101g}$ described above may be the same or different from one another. Specific examples of the alkyl group include, but are not limited to the following, a methyl group, an ethyl group, a propyl group, an isopropyl group, a n-butyl group, a sec-butyl group, a tert-butyl group, a pentyl group, a hexyl group, a heptyl group, an octyl group, a cyclopentyl group, a cyclohexyl group, a cycloheptyl group, a cyclopropylmethyl group, a 4-methyl cyclohexyl group, a cyclohexylmethyl group, a norbornyl group, and an adamantyl group. Examples of the alkenyl group include, but are not limited to the following, a vinyl group, an allyl group, a propenyl group, a butenyl group, a hexenyl group, and a cyclohexenyl group. Examples of the oxoalkyl group can include, but are not limited to the following, a 2-oxocyclopentyl group, a 2-oxocyclohexyl group, a 2-oxopropyl group, a 2-cyclopentyl-2-oxoethyl group, a 2-cyclohexyl-2-oxoethyl group, and a 2-(4-methylcyclohexyl)-2-oxoethyl group. Examples of the oxoalkenyl group include, but are not limited to the following, a 2-oxo-4-cyclohexenyl group and a 2-oxo-4-propenyl group. Examples of the aryl group include, but are not limited to the following, a phenyl group, a naphthyl group, alkoxyphenyl groups such as a p-methoxyphenyl group, a m-methoxyphenyl group, an o-methoxyphenyl group, an ethoxyphenyl group, a p-tert-butoxyphenyl group, and a m-tert-butoxyphenyl group; alkylphenyl groups such as a 2-methylphenyl group, a 3-methylphenyl group, a 4-methylphenyl group, an ethylphenyl group, a 4-tert-butylphenyl group, a 4-butylphenyl group, and a dimethylphenyl group; alkylnaphthyl groups such as a methylnaphthyl group and an ethylnaphthyl group; alkoxynaphthyl groups such as a methoxynaphthyl group and an ethoxynaphthyl group; dialkylnaphthyl groups such as a dimethylnaphthyl group and a diethylnaphthyl group; and dialkoxynaphthyl groups such as a dimethoxynaphthyl group and a diethoxynaphthyl group. Examples of the aralkyl group include, but are not limited to the following, a benzyl group, a phenylethyl group, and a phenethyl group. Examples of the aryloxoalkyl group include, but are not limited to the following, 2-aryl-2-oxoethyl groups such as a 2-phenyl-2-oxoethyl group, a 2-(1-naphthyl)-2-oxoethyl group, and a 2-(2-naphthyl)-2-oxoethyl group. Examples of the non-nucleophilic counter ion, $K^-$, include, but are not limited to the following, halide ions such as a chloride ion and a bromide ion; fluoroalkyl sulfonates such as triflate, 1,1,1-trifluoroethane sulfonate, and nonafluorobutane sulfonate; aryl sulfonates such as tosylate, benzene sulfonate, 4-fluorobenzene sulfonate, and 1,2,3,4,5-pentafluorobenzene sulfonate; and alkyl sulfonates such as mesylate and butane sulfonate.

In addition, when $R^{101d}$, $R^{101e}$, $R^{101f}$ and $R^{101g}$ represent a heteroaromatic ring having therein the nitrogen atom(s) in the formula, examples of the heteroaromatic ring include, for example, imidazole derivatives (for example, imidazole, 4-methylimidazole, and 4-methyl-2-phenylimidazole), pyrazole derivatives, furazan derivatives, pyrroline derivatives (for example, pyrroline and 2-methyl-1-pyrroline), pyrrolidine derivatives (for example, pyrrolidine, N-methylpyrrolidine, pyrrolidinone, and N-methylpyrrolidone), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridone, 4-pyrrolidinopyridine, 1-methyl-4-phenylpyridine, 2-(1-ethylpropyl)pyridine, aminopyridine, and dimethylaminopyridine), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (for example, quinoline and 3-quinolinecarbonitrile), isoquinoline derivatives, cinnoline derivatives, quinazoline derivatives, quinoxaline derivatives, phthalazine derivatives, purine derivatives, pteridin derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivative, and uridine derivatives.

The onium salts represented by the formula (P1a-1) and formula (P1a-2) have functions as a photo acid generator and a thermal acid generator. The onium salt represented by the formula (P1a-3) has a function as a thermal acid generator.

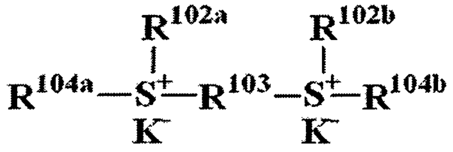

(P1b)

In formula (P1b), each of $R^{102a}$ and $R^{102b}$ independently represents a straight, branched or cyclic alkyl group having 1 to 8 carbon atoms. $R^{103}$ represents a straight, branched or cyclic alkylene group having 1 to 10 carbon atoms. Each of $R^{104}$a and $R^{104b}$ independently represents a 2-oxoalkyl group having 3 to 7 carbon atoms. $K^-$represents a non-nucleophilic counter ion.

Specific examples of each of $R^{102a}$ and $R^{102b}$ independently include, but are not limited to the following, a methyl group, an ethyl group, a propyl group, an isopropyl group, a n-butyl group, a sec-butyl group, a tert-butyl group, a pentyl group, a hexyl group, a heptyl group, an octyl group, a cyclopentyl group, a cyclohexyl group, a cyclopropylmethyl group, a 4-methylcyclohexyl group and a cyclohexylmethyl group. Specific examples of $R^{103}$ include, but are not limited to the following, a methylene group, an ethylene group, a propylene group, a butylene group, a pentylene group, a hexylene group, a heptylene group, an octylene group, nonylene group, a 1,4-cyclohexylene group, a 1,2-cyclohexylene group, a 1,3-cyclopentylene group, a 1,4-cyclooctylene group and a 1,4-cyclohexanedimethylene group. Specific examples of each of $R^{104a}$ and $R^{104b}$ independently include, but are not limited to the following, a 2-oxopropyl group, a 2-oxocyclopentyl group, a 2-oxocyclohexyl group and a 2-oxocycloheptyl group. $K^-$ includes the same as those described in the formulae (P1a-1), (P1a-2) and (P1a-3).

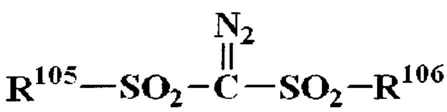

(P2)

In the formula (P2), each of $R^{105}$ and $R^{106}$ independently represents a straight, branched or cyclic alkyl group or halogenated alkyl group having 1 to 12 carbon atoms, an aryl group or halogenated aryl group having 6 to 20 carbon atoms, or an aralkyl group having 7 to 12 carbon atoms.

Examples of the alkyl group represented by each of $R^{105}$ and $R^{106}$ independently include, but are not limited to the following, a methyl group, an ethyl group, a propyl group, an isopropyl group, a n-butyl group, a sec-butyl group, a tert-butyl group, a pentyl group, a hexyl group, a heptyl group, an octyl group, an amyl group, a cyclopentyl group, a cyclohexyl group, a cycloheptyl group, a norbornyl group and an adamantyl group. Examples of the halogenated alkyl group include, but are not limited to the following, a trifluoromethyl group, a 1,1,1-trifluoroethyl group, a 1,1,1-trichloroethyl group, and a nonafluorobutyl group. Examples of the aryl group include, but are not limited to the following, alkoxyphenyl groups such as a phenyl group, a p-methoxyphenyl group, a m-methoxyphenyl group, an o-methoxyphenyl group, an ethoxyphenyl group, a p-tert-butoxyphenyl group, and a m-tert-butoxyphenyl group; and alkylphenyl groups such as a 2-methylphenyl group, a 3-methylphenyl group, a 4-methylphenyl group, an ethylphenyl group, a 4-tert-butylphenyl group, a 4-butylphenyl group, and a dimethylphenyl group. Examples of the halogenated aryl group include, but are not limited to the following, a fluorophenyl group, a chlorophenyl group, and a 1,2,3,4,5-pentafluorophenyl group. Examples of the aralkyl group include, but are not limited to the following, a benzyl group and a phenethyl group.

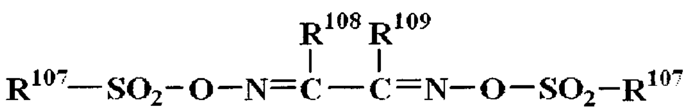

(P3)

In formula (P3), each of $R^{107}$, $R^{108}$ and $R^{109}$ independently represents a straight, branched or cyclic alkyl group or halogenated alkyl group having 1 to 12 carbon atoms; an aryl group or halogenated aryl group having 6 to 20 carbon

atoms; or an aralkyl group having 7 to 12 carbon atoms. $R^{108}$ and $R^{109}$ may be bonded to each other to form a cyclic structure, and if forming a cyclic structure, each of $R^{108}$ and $R^{109}$ independently represents a straight or branched alkylene group having 1 to 6 carbon atoms.

The alkyl group, halogenated alkyl group, aryl group, halogenated aryl group, and aralkyl group in each of $R^{107}$, $R^{108}$ and $R^{109}$ include the same as those described in $R^{105}$ and $R^{106}$. Herein, examples of the alkylene group in each of $R^{108}$ and $R^{109}$ include, but are not limited to the following, a methylene group, an ethylene group, a propylene group, a butylene group, and a hexylene group.

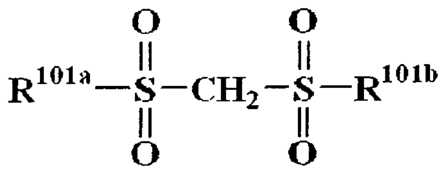

(P4)

In formula (P4), $R^{101a}$ and $R^{102b}$ are the same as those described above.

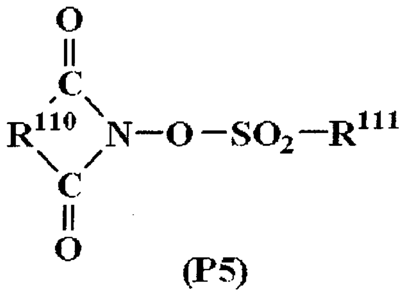

(P5)

In the formula (P5), $R^{110}$ represents an arylene group having 6 to 10 carbon atoms, an alkylene group having 1 to 6 carbon atoms, or an alkenylene group having 2 to 6 carbon atoms, and a part or all of hydrogen atoms of these groups may be further substituted with a straight or branched alkyl group or alkoxy group having 1 to 4 carbon atoms, a nitro group, an acetyl group, or a phenyl group. $R^{111}$ represents a straight, branched or substituted alkyl group, alkenyl group or alkoxyalkyl group having 1 to 8 carbon atoms, a phenyl group, or a naphthyl group. A part or all of hydrogen atoms of these groups may be further substituted with an alkyl group or alkoxy group having 1 to 4 carbon atoms, a nitro group, an acetyl group, or a phenyl group. $R^{111}$ represents a straight, branched or substituted alkyl group, alkenyl group or alkoxyalkyl group having 1 to 8 carbon atoms, a phenyl group, or a naphthyl group. A part or all of hydrogen atoms of these groups may be further substituted with an alkyl group or alkoxy group having 1 to 4 carbon atoms; a phenyl group that may be substituted with an alkyl group or alkoxy group having 1 to 4 carbon atoms, a nitro group or an acetyl group; a heteroaromatic group having 3 to 5 carbon atoms; or a chlorine atom or a fluorine atom.

Herein, examples of the arylene group in $R^{110}$ include, but are not limited to the following, a 1,2-phenylene group and a 1,8-naphthylene group. Examples of the alkylene group include, but are not limited to the following, a methylene group, an ethylene group, a trimethylene group, a tetramethylene group, a phenylethylene group, and a norbornane-2,3-diyl group. Examples of the alkenylene group include, but are not limited to the following, a 1,2-vinylene group, a 1-phenyl-1,2-vinylene group, and a 5-norbornene-2,3-diyl group. The alkyl group in $R^{111}$ includes the same as those in $R^{101}$a to $R^{101c}$. Examples of the alkenyl group include, but are not limited to the following, a vinyl group, a 1-propenyl group, an allyl group, a 1-butenyl group, a 3-butenyl group, an isoprenyl group, a 1-pentenyl group, a 3-pentenyl group, a 4-pentenyl group, a dimethylallyl group, a 1-hexenyl group, a 3-hexenyl group, a 5-hexenyl group, a 1-heptenyl group, a 3-heptenyl group, a 6-heptenyl group, and a 7-octenyl group. Examples of the alkoxyalkyl group include, but are not limited to the following, a methoxymethyl group, an ethoxymethyl group, a propoxymethyl group, a butoxymethyl group, a pentyloxymethyl group, a hexyloxymethyl group, a heptyloxymethyl group, a methoxyethyl group, an ethoxyethyl group, a propoxyethyl group, a butoxyethyl group, a pentyloxyethyl group, a hexyloxyethyl group, a methoxypropyl group, an ethoxypropyl group, a propoxypropyl group, a butoxypropyl group, a methoxybutyl group, an ethoxybutyl group, a propoxybutyl group, a methoxypentyl group, an ethoxypentyl group, a methoxyhexyl group, and a methoxyheptyl group.

Herein, Examples of the alkyl group having 1 to 4 carbon atoms, which may be further substituted, include, but are not limited to the following, a methyl group, an ethyl group, a propyl group, an isopropyl group, a n-butyl group, an isobutyl group, and a tert-butyl group. Examples of the alkoxy group having 1 to 4 carbon atoms include, but are not

limited to the following, a methoxy group, an ethoxy group, a propoxy group, an isopropoxy group, a n-butoxy group, an isobutoxy group, and tert-butoxy group. Examples of the phenyl group that may be substituted with an alkyl group or alkoxy group having 1 to 4 carbon atoms, a nitro group, or an acetyl group include, but are not limited to the following, a phenyl group, a tolyl group, a p-tert-butoxyphenyl group, a p-acetylphenyl group, and a p-nitrophenyl group. Examples of the heteroaromatic group having 3 to 5 carbon atoms include, but are not limited to the following, a pyridyl group and a furyl group.

Specific examples of the acid generator include, but are not limited to, for example, the following, onium salts such as tetramethylammonium trifluoromethanesulfonate, tetramethylammonium nonafluorobutanesulfonate, triethylammonium nonafluorobutanesulfonate, pyridinium nonafluorobutanesulfonate, triethylammonium camphorsulfonate, pyridinium camphorsulfonate, tetra n-butylammonium nonafluorobutanesulfonate, tetraphenylammonium nonafluorobutanesulfonate, tetramethylammonium p-toluenesulfonate, diphenyliodonium trifluoromethanesulfonate, (p-tert-butoxyphenyl)phenyliodonium trifluoromethanesulfonate, diphenyliodonium p-toluenesulfonate, (p-tert-butoxyphenyl)phenyliodonium p-toluenesulfonate, triphenylsulfonium trifluoromethanesulfonate, (p-tert-butoxyphenyl)diphenylsulfonium trifluoromethanesulfonate, bis(p-tert-butoxyphenyl)phenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, bis(p-tert-butoxyphenyl)phenylsulfonium p-toluenesulfonate, tris(p-tert-butoxyphenyl)sulfonium p-toluenesulfonate, triphenylsulfonium nonafluorobutanesulfonate, triphenylsulfonium butanesulfonate, trimethylsulfonium trifluoromethanesulfonate, trimethylsulfonium p-toluenesulfonate, cyclohexylmethyl(2-oxocyclohexyl)sulfonium trifluoromethanesulfonate, cyclohexylmethyl(2-oxocyclohexyl)sulfonium p-toluenesulfonate, dimethylphenylsulfonium trifluoromethanesulfonate, dimethylphenylsulfonium p-toluenesulfonate, dicyclohexylphenylsulfonium trifluoromethanesulfonate, dicyclohexylphenylsulfonium p-toluenesulfonate, trinaphthylsulfonium trifluoromethanesulfonate, cyclohexylmethyl(2-oxocyclohexyl)sulfonium trifluoromethanesulfonate, (2-norbornyl)methyl(2-oxocyclohexyl)sulfonium trifluoromethanesulfonate, ethylene bis[methyl(2-oxocyclopentyl)sulfonium trifluoromethanesulfonate], and 1,2'-naphthylcarbonylmethyltetrahydrothiophenium triflate;

diazomethane derivatives such as bis(benzenesulfonyl)diazomethane, bis(p-toluenesulfonyl)diazomethane, bis(xylenesulfonyl)diazomethane, bis(cyclohexylsulfonyl)diazomethane, bis(cyclopentylsulfonyl)diazomethane, bis(n-butylsulfonyl)diazomethane, bis(isobutylsulfonyl)diazomethane, bis(sec-butylsulfonyl)diazomethane, bis(n-propylsulfonyl)diazomethane, bis(isopropylsulfonyl)diazomethane, bis(tert-butylsulfonyl)diazomethane, bis(n-amylsulfonyl)diazomethane, bis(isoamylsulfonyl)diazomethane, bis(sec-amylsulfonyl)diazomethane, bis(tert-amylsulfonyl)diazomethane, 1-cyclohexylsulfonyl-1-(tert-butylsulfonyl)diazomethane, 1-cyclohexylsulfonyl-1-(tert-amylsulfonyl)diazomethane, and 1-tert-amylsulfonyl-1-(tert-butylsulfonyl)diazomethane; glyoxime derivatives such as bis-(p-toluenesulfonyl)-$\alpha$-dimethylglyoxime, bis-(p-toluesulfonyl)-$\alpha$-diphenylglyoxime, bis-(p-toluenesulfonyl)-$\alpha$-dicyclohexylglyoxime, bis-(p-toluenesulfonyl)-2,3-pentanedioneglyoxime, bis-(p-toluenesulfonyl)-2-methyl-3,4-pentanedioneglyoxime, bis-(n-butanesulfonyl)-$\alpha$-dimethylglyoxime, bis-(n-butanesulfonyl)-$\alpha$-diphenylglyoxime, bis-(n-butanesulfonyl)-$\alpha$-dicyclohexylglyoxime, bis-(n-butanesulfonyl)-2,3-pentanedioneglyoxime, bis-(n-butanesulfonyl)-2-methyl-3,4-pentanedioneglyoxime, bis-(methanesulfonyl)- $\alpha$-dimethylglyoxime, bis-(trifluoromethanesulfonyl)-$\alpha$-dimethylglyoxime, bis-(1,1,1-trifluoroethanesulfonyl)-$\alpha$-dimethylglyoxime, bis-(tert-butanesulfonyl)-$\alpha$-dimethylglyoxime, bis-(perfluorooctanesulfonyl)-$\alpha$-dimethylglyoxime, bis-(cyclohexanesulfonyl)-$\alpha$-dimethylglyoxime, bis-(benzenesulfonyl)-$\alpha$-dimethylglyoxime, bis-(p-fluorobenzenesulfonyl)-$\alpha$-dimethylglyoxime, bis-(p-tert-butylbenzenesulfonyl)-$\alpha$-dimethylglyoxime, bis-(xylenesulfonyl)-$\alpha$-dimethylglyoxime, and bis-(camphorsulfonyl)-$\alpha$-dimethylglyoxime;

bissulfone derivatives, such as bisnaphthylsulfonylmethane, bistrifluoromethylsulfonylmethane, bismethylsulfonylmethane, bisethylsulfonylmethane, bispropylsulfonylmethane, bisisopropylsulfonylmethane, bis-p-toluenesulfonylmethane, and

bisbenzenesulfonylmethane; $\beta$-ketosulfone derivatives such as 2-cyclohexylcarbonyl-2-(p-toluenesulfonyl)propane and 2-isopropylcarbonyl-2-(p-toluenesulfonyl)propane; disulfone derivatives such as a diphenyldisulfone derivative and a dicyclohexyldisulfone derivative, nitrobenzylsulfonate derivatives such as 2,6-dinitrobenzyl p-toluenesulfonate and 2,4-dinitrobenzyl p-toluenesulfonate; sulfonic acid ester derivatives such as 1,2,3-tris(methanesulfonyloxy)benzene, 1,2,3-tris(trifluoromethanesulfonyloxy)benzene, and 1,2,3-tris(p-toluenesulfonyloxy)benzene; and sulfonic acid ester derivatives of a N-hydroxyimide compound, such as N-hydroxysuccinimide methanesulfonic acid ester, N-hydroxysuccinimide trifluoromethanesulfonic acid ester, N-hydroxysuccinimide ethanesulfonic acid ester, N-hydroxysuccinimide 1-propanesulfonic acid ester, N-hydroxysuccinimide 2-propanesulfonic acid ester, N-hydroxysuccinimide 1-pentanesulfonic acid ester, N-hydroxysuccinimide 1-octanesulfonic acid ester, N-hydroxysuccinimide p-toluenesulfonic acid ester, N-hydroxysuccinimide p-methoxybenzenesulfonic acid ester, N-hydroxysuccinimide 2-chloroethanesulfonic acid ester, N-hydroxysuccinimide benzenesulfonic acid ester, N-hydroxysuccinimide -2,4,6-trimethylbenzenesulfonic acid ester, N-hydroxysuccinimide 1-naphthalenesulfonic acid ester, N-hydroxysuccinimide 2-naphthalenesulfonic acid ester, N-hydroxy-2-phenylsuccinimide methanesulfonic acid ester, N-hydroxymaleimide methanesulfonic acid ester, N-hydroxymaleimide ethanesulfonic acid ester, N-hydroxy-2-phenylmaleimide methanesulfonic acid ester, N-hydroxyglutarimide methanesulfonic acid ester, N-hydroxyglutarimide benzenesulfonic acid ester, N-hydroxyphthalimide methanesulfonic

acid ester, N-hydroxyphthalimide benzenesulfonic acid ester, N-hydroxyphthalimide trifluoromethanesulfonic acid ester, N-hydroxyphthalimide p-toluenesulfonic acid ester, N-hydroxynaphthalimide methanesulfonic acid ester, N-hydroxynaphthalimide benzenesulfonic acid ester, N-hydroxy-5-norbornene-2,3-dicarboxyimide methanesulfonic acid ester, N-hydroxy-5-norbornene-2,3-dicarboxyimide trifluoromethanesulfonic acid ester, and N-hydroxy-5-norbornene-2,3-dicarboxyimide p-toluenesulfonic acid ester.

Among them, in particular, onium salts such as triphenylsulfonium trifluoromethanesulfonate, (p-tert-butoxyphenyl)diphenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, tris(p-tert-butoxyphenyl)sulfonium p-toluenesulfonate, trinaphthylsulfonium trifluoromethanesulfonate, cyclohexylmethyl(2-oxocyclohexyl)sulfonium trifluoromethanesulfonate, (2-norbornyl)methyl(2-oxocyclohexyl)sulfonium trifluoromethanesulfonate, and 1,2'-naphthylcarbonylmethyltetrahydrothiophenium triflate; diazomethane derivatives such as bis(benzenesulfonyl)diazomethane, bis(p-toluenesulfonyl)diazomethane, bis(cyclohexylsulfonyl)diazomethane, bis(n-butylsulfonyl)diazomethane, bis(isobutylsulfonyl)diazomethane, bis(sec-butylsulfonyl)diazomethane, bis(n-propylsulfonyl)diazomethane, bis(isopropylsulfonyl)diazomethane, and bis(tert-butylsulfonyl)diazomethane; glyoxime derivatives such as bis-(p-toluenesulfonyl)-$\alpha$-dimethylglyoxime and bis-(n-butanesulfonyl)-$\alpha$-dimethylglyoxime, bissulfone derivatives such as bisnaphthylsulfonylmethane; and sulfonic acid ester derivatives of an N-hydroxyimide compound, such as N-hydroxysuccinimide methanesulfonic acid ester, N-hydroxysuccinimide trifluoromethanesulfonic acid ester, N-hydroxysuccinimide 1-propanesulfonic acid ester, N-hydroxysuccinimide 2-propanesulfonic acid ester, N-hydroxysuccinimide 1-pentanesulfonic acid ester, N-hydroxysuccinimide p-toluenesulfonic acid ester, N-hydroxynaphthalimide methanesulfonic acid ester, and N-hydroxynaphthalimide benzenesulfonic acid ester, and the like are preferably used.

The content of the acid generator in the composition for forming an underlayer film for lithography of the present embodiment is not particularly limited, but it is preferably 0.0 parts by mass or more and 50 parts by mass or less, more preferably 0.0 parts by mass or more and 40 parts by mass or less based on 100 parts by mass of the cyanic acid ester compound. The content is set within the above preferable range to result in tendency to promote a crosslinking reaction, and also to result in a tendency to suppress the occurrence of the mixing phenomenon with a resist layer.

The composition for forming an underlayer film for lithography of the present embodiment may further contain a basic compound from the viewpoint of enhancing storage stability.

The basic compound serves as a quencher to an acid for preventing a trace amount of the acid generated from the acid generator from promoting a crosslinking reaction. Examples of such a basic compound include primary, secondary, and tertiary aliphatic amines, mixed amines, aromatic amines, heterocyclic amines, a nitrogen-containing compound having a carboxy group, a nitrogen-containing compound having a sulfonyl group, a nitrogen-containing compound having a hydroxyl group, a nitrogen-containing compound having a hydroxyphenyl group, an alcoholic nitrogen-containing compound, an amide derivative, and an imide derivative, but are not particularly limited thereto.

Specific examples of the primary aliphatic amines include, but are not limited to, for example the following, ammonia, methylamine, ethylamine, n-propylamine, isopropylamine, n-butylamine, isobutylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine, and tetraethylenepentamine. Specific examples of the secondary aliphatic amines include, but are not limited to, for example the following, dimethylamine, diethylamine, di-n-propylamine, diisopropylamine, di-n-butylamine, diisobutylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dimethylethylenediamine, and N,N-dimethyltetraethylenepentamine. Specific examples of the tertiary aliphatic amines include, but are not limited to, for example the following, trimethylamine, triethylamine, tri-n-propylamine, triisopropylamine, tri-n-butylamine, triisobutylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N'-tetramethylmethylenediamine, N,N,N',N'-tetramethylethylenediamine, and N,N,N',N'-tetramethyltetraethylenepentamine.

Specific examples of the mixed amines include, but are not limited to, for example the following, dimethylethylamine, methylethylpropylamine, benzylamine, phenethylamine, and benzyldimethylamine. Specific examples of the aromatic amines and heterocyclic amines include, but are not limited to, for example the following, aniline derivatives (for example, aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2,4-dinitroaniline, 2,6-dinitroaniline, 3,5-dinitroaniline, and N,N-dimethyltoluidine), diphenyl(p-tolyl)amine, methyldiphenylamine, triphenylamine, phenylenediamine, naphthylamine, diaminonaphthalene, pyrrole derivatives (for example, pyrrole, 2H-pyrrole, 1-methylpyrrole, 2,4-dimethylpyrrole, 2,5-dimethylpyrrole, and N-methylpyrrole), oxazole derivatives (for example, oxazole and isoxazole), thiazole derivatives (for example, thiazole and isothiazole), imidazole derivatives (for example, imidazole, 4-methylimidazole, and 4-methyl-2-phenylimidazole), pyrazole derivatives, furazan derivatives, pyrroline derivatives (for example, pyrroline and 2-methyl-1-pyrroline), pyrrolidine derivatives (for example, pyrrolidine, N-methylpyrrolidine, pyrrolidinone, and N-methylpyrrolidone), imidazoline derivatives, imidazolidine derivatives, pyridine

derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridone, 4-pyrrolidinopyridine, 1-methyl-4-phenylpyridine, 2-(1-ethylpropyl)pyridine, aminopyridine, and dimethylaminopyridine), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (for example, quinoline, 3-quinolinecarbonitrile), isoquinoline derivatives, cinnoline derivatives, quinazoline derivatives, quinoxaline derivatives, phthalazine derivatives, purine derivatives, pteridin derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, and uridine derivatives.

Furthermore, specific examples of the nitrogen-containing compound having a carboxy group include, but are not limited to, for example the following, aminobenzoic acid, indolecarboxylic acid, and amino acid derivatives (for example, nicotinic acid, alanine, arginine, aspartic acid, glutamic acid, glycine, histidine, isoleucine, glycylleucine, leucine, methionine, phenylalanine, threonine, lysine, 3-aminopyrazine-2-carboxylic acid, and methoxyalanine). Specific examples of the nitrogen-containing compound having a sulfonyl group include, but are not limited to, for example the following, 3-pyridinesulfonic acid and pyridinium p-toluenesulfonate. Specific examples of the nitrogen-containing compound having a hydroxyl group, the nitrogen-containing compound having a hydroxyphenyl group, and the alcoholic nitrogen-containing compound include, but are not limited to, for example the following, 2-hydroxypyridine, aminocresol, 2,4-quinolinediol, 3-indolemethanol hydrate, monoethanolamine, diethanolamine, triethanolamine, N-ethyldiethanolamine, N,N-diethylethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl)pyridine, 1-(2-hydroxyethyl)piperazine, 1-[2-(2-hydroxyethoxy)ethyl]piperazine, piperidine ethanol, 1-(2-hydroxyethyl)pyrrolidine, 1-(2-hydroxyethyl)-2-pyrrolidone, 3-piperidino-1,2-propanediol, 3-pyrrolidino-1,2-propanediol, 8-hydroxyjulolidine, 3-quinuclidinol, 3-tropanol, 1-methyl-2-pyrrolidine ethanol, 1-aziridine ethanol, N-(2-hydroxyethyl)phthalimide, and N-(2-hydroxyethyl)isonicotinamide. Specific examples of the amide derivative include, but are not limited to, for example the following, formamide, N-methylformamide, N,N-dimethylformamide, acetamide, N-methylacetamide, N,N-dimethylacetamide, propionamide, and benzamide. Specific examples of the imide derivative include, but are not limited to, for example the following, phthalimide, succinimide, and maleimide.

The content of the basic compound in the composition for forming an underlayer film for lithography of the present embodiment is not particularly limited, but it is preferably 0.0 parts by mass or more and 2.0 parts by mass or less, more preferably 0.0 parts by mass or more and 1.0 parts by mass or less based on 100 parts by mass of the cyanic acid ester compound. The content is set within the above preferable range to result in a tendency to improve preservation stability without excessively interrupting a crosslinking reaction.

In addition, the composition for forming an underlayer film for lithography of the present embodiment may contain other resins and/or compounds for the purpose of imparting heat curability and controlling absorbance. Such other resins and/or compounds include naphthol resins, xylene resins naphthol-modified resins, phenol-modified resins of naphthalene resins, polyhydroxystyrene, dicyclopentadiene resins, (meth)acrylate, dimethacrylate, trimethacrylate, tetramethacrylate, resins having a naphthalene ring such as vinylnaphthalene and polyacenaphthylene; resins having a biphenyl ring such as phenanthrenequinone and fluorene; resins having a heterocyclic ring having a hetero atom such as thiophene and indene, and resins not containing an aromatic ring; rosin-based resins, and resins and compounds including an alicyclic structure, such as cyclodextrin, adamantane(poly)ol, tricyclodecane(poly)ol and derivatives thereof, but are not particularly limited thereto. Furthermore, the composition for forming an underlayer film for lithography of the present embodiment can also contain a known additive. Examples of the known additive includes, but not limited to the following, an ultraviolet absorber, a surfactant, a colorant and a nonionic surfactant.

[Forming Method of underlayer Film for Lithography and Pattern]

An underlayer film for lithography of the present embodiment is formed by using the composition for forming an underlayer film for lithography of the present embodiment.

In addition, a resist pattern forming method of the present embodiment includes step (A-1) of forming an underlayer film on a substrate by using the composition for forming an underlayer film for lithography of the present embodiment, step (A-2) of forming at least one photoresist layer on the underlayer film, and step (A-3) of irradiating a predetermined region of the photoresist layer with radiation, and developing it.

Furthermore, a circuit pattern forming method of the present embodiment includes step (B-1) of forming an underlayer film on a substrate by using the composition for forming an underlayer film for lithography of the present embodiment, step (B-2) of forming an intermediate layer film on the underlayer film by using a silicon atom-containing resist intermediate layer film material, step (B-3) of forming at least one photoresist layer on the intermediate layer film, step (B-4) of irradiating a predetermined region of the photoresist layer with radiation, to form a resist pattern by developing,

step (B-5) of etching the intermediate layer film with the resist pattern as a mask, to form an intermediate layer film pattern, step (B-6) of etching the underlayer film with the intermediate layer film pattern as an etching mask, to form an underlayer film pattern, and step (B-7) of etching the substrate with the underlayer film pattern as an etching mask, to form a substrate pattern.

The underlayer film for lithography of the present embodiment is not particularly limited in terms of the forming method thereof as long as it is formed from the composition for forming an underlayer film for lithography of the present embodiment, and a known method can be applied. For example, the underlayer film can be formed by applying the composition for forming an underlayer film for lithography of the present embodiment on the substrate by a known coating method or printing method such as spin coating or screen printing, and removing an organic solvent by volatilization or the like.

The underlayer film is preferably baked upon forming in order to suppress the occurrence of the mixing phenomenon with an upperlayer resist and also promote a crosslinking reaction. In this case, the baking temperature is not particularly limited, but it is preferably within the range of 80 to 450°C, and more preferably 200 to 400°C. In addition, the baking time is not also particularly limited, but is preferably within the range of 10 to 300 seconds. Herein, the thickness of the underlayer film can be appropriately selected depending on the required properties, and is not particularly limited, but the thickness is preferably 30 nm or more and 20000 nm or less, more preferably 50 nm or more and 15000 nm or less.

After the underlayer film is prepared on the substrate, preferably, in the case of a two-layer process, a silicon-containing resist layer or a usual single-layer resist including a hydrocarbon is prepared on the film for lithography, and in the case of a three-layer process, a silicon-containing intermediate layer is prepared on the film for lithography and a single-layer resist layer not containing silicon is further prepared on the silicon-containing intermediate layer. In these cases, a photoresist material for forming the resist layer, which can be used, is a known one.

As the silicon-containing resist material for a two-layer process, a positive-type photoresist material is preferably used, which contains a silicon atom-containing polymer such as a polysilsesquioxane derivative or a vinylsilane derivative used as a base polymer in the viewpoint of oxygen gas-etching resistance, and an organic solvent, an acid generator and if necessary a basic compound. Herein, as the silicon atom-containing polymer, a known polymer used in such a resist material can be used.

As the silicon-containing intermediate layer for a three-layer process, a polysilsesquioxane-based intermediate layer is preferably used. The intermediate layer is allowed to have an effect as an antireflective film, and thus tends to make it possible to effectively suppress reflection. For example, if a material including many aromatic groups and having a high substrate-etching resistance is used for the underlayer film in a 193 nm exposure process, a k-value tends to be increased to increase substrate reflection, but the reflection can be suppressed by the intermediate layer to thereby make the substrate reflection 0.5% or less. For the intermediate layer having such an antireflection effect, but not limited to the following, polysilsesquioxane into which a phenyl group or a light-absorbing group having a silicon-silicon bond for 193 nm exposure is introduced and which is to be crosslinked with an acid or heat is preferably used.

An intermediate layer formed by the Chemical Vapour Deposition (CVD) method can also be used. As the intermediate layer having a high effect as an antireflective film, prepared by the CVD method, but not limited to the following, for example, a SiON film is known. In general, the intermediate layer is formed by a wet process such as a spin coating method or screen printing rather than the CVD method in terms of simplicity and cost effectiveness. Herein, the upperlayer resist in a three-layer process may be of positive-type or negative-type, and the same one as a commonly used single-layer resist can be used therefor.

Furthermore, the underlayer film of the present embodiment can also be used as a usual antireflective film for use in a single-layer resist or a usual underlying material for suppressing pattern collapse. The underlayer film of the present embodiment can also be expected to serve as a hard mask for underlying processing because of being excellent in etching resistance for underlying processing.

In the case where a resist layer is formed by the photoresist material, a wet process such as a spin coating method or screen printing is preferably used as in the case of forming the underlayer film. The resist material is coated by a spin coating method or the like and then usually pre-baked, and such pre-baking is preferably performed in the range of 80 to 180°C for 10 to 300 seconds. Thereafter, in accordance with an ordinary method, the resultant can be subjected to exposure, post-exposure bake (PEB), and development to obtain a resist pattern. Herein, the thickness of the resist film is not particularly limited, but it is preferably 30 nm or more and 500 nm or less, more preferably 50 nm or more and 400 nm or less.

Light for use in exposure may be appropriately selected depending on the photoresist material to be used. Examples of light for use in exposure can include high energy radiation having a wavelength of 300 nm or less, specifically, excimer lasers of 248 nm, 193 nm, and 157 nm, a soft X-ray of 3 to 20 nm, electron beam, and an X-ray.

The resist pattern formed by the above method is a pattern whose collapse is suppressed by the underlayer film of the present embodiment. Therefore, the underlayer film of the present embodiment can be used to thereby obtain a finer pattern, and an exposure amount necessary for obtaining such a resist pattern can be reduced.

Then, the obtained resist pattern is used as a mask to perform etching. As the etching of the underlayer film in a two-layer process, gas etching is preferably used. As the gas etching, etching using oxygen gas is suitable. In addition to oxygen gas, an inert gas such as He and Ar, and CO, $CO_2$ $NH_3$, $SO_2$, $N_2$, $NO_2$, and $H_2$ gases can also be added. The gas etching can also be performed not using oxygen gas but using only CO, $CO_2$, $NH_3$, $N_2$, $NO_2$, and $H_2$ gases. In particular, the latter gases are preferably used for protecting a side wall for preventing a pattern side wall from being undercut.

On the other hand, also in the etching of the intermediate layer in a three-layer process, gas etching is preferably used. As the gas etching, the same one as the one described in a two-layer process can be applied. In particular, the intermediate layer is preferably processed in a three-layer process using a fluorocarbon gas with the resist pattern as a mask. Thereafter, as described above, the intermediate layer pattern is used as a mask to perform, for example, oxygen gas etching, thereby processing the underlayer film.

Herein, in the case where an inorganic hard mask intermediate layer film is formed as the intermediate layer, a silicon oxide film, a silicon nitride film, and a silicon oxynitride film (SiON film) are formed by the CVD method, the ALD method, and the like. The nitride film forming method that can be used is, but not limited to the following, any method described in, for example, Japanese Patent Laid-Open No. 2002-334869 (Patent Literature 6) and WO2004/066377 (Patent Literature 7). While the photoresist film can be directly formed on such an intermediate layer film, an organic antireflective film (BARC) may also be formed on the intermediate layer film by spin coating, and the photoresist film may also be formed thereon.

As the intermediate layer, a polysilsesquioxane-based intermediate layer is also preferably used. The resist intermediate layer film is allowed to have an effect as an antireflective film, and thus tends to make it possible to effectively suppress reflection. A specific material for the polysilsesquioxane-based intermediate layer that can be used is, but not limited to the following, any material described in, for example, Japanese Patent Laid-Open No. 2007-226170 (Patent Literature 8) and Japanese Patent Laid-Open No. 2007-226204 (Patent Literature 9).

The next etching of the substrate can also be performed by an ordinary method, and, for example, when the substrate is made of $SiO_2$ or SiN, etching with mainly a fluorocarbon gas can be performed, and when the substrate is made of p-Si, Al, or W, etching mainly using a chlorine-based gas or bromine-based gas can be performed. In the case where the substrate is processed by the etching with a fluorocarbon gas, the silicon-containing resist in a two-layer resist process and the silicon-containing intermediate layer in a three-layer process are peeled off at the same time as the processing of the substrate. On the other hand, in the case where the substrate is processed by the etching with a chlorine-based gas or bromine-based gas, the silicon-containing resist layer or the silicon-containing intermediate layer is peeled off separately, and is generally peeled off by dry etching with a fluorocarbon gas after the substrate is processed.

The underlayer film of the present embodiment is excellent in etching resistance of such a substrate. The substrate that can be used is appropriately selected from known ones, and is not particularly limited, but includes Si, $\alpha$-Si, p-Si, $SiO_2$, SiN, SiON, W, TiN, and Al substrates. In addition, the substrate may also be a laminate having a processed film (processed substrate) on a base material (support). Such a processed film includes various Low-k films made of Si, $SiO_2$, SiON, SiN, p-Si, $\alpha$-Si, W, W-Si, Al, Cu, and Al-Si, and stopper films thereof, and a material different from the base material (support) is preferably used therefor. Herein, the thickness of the substrate to be processed or the processed film is not particularly limited, but it is preferably 50 nm or more and 10,000 nm or less, more preferably 75 to 5,000 nm.

## Examples

Hereinafter, the present embodiment will be described in more detail by Synthesis Examples, Examples and Comparative Examples, but the present embodiment is not limited thereto at all.

### [Carbon Concentration and Oxygen Concentration]

The carbon concentration and the oxygen concentration (% by mass) were measured by organic element analysis with the following apparatus.

Apparatus: CHN CORDER MT-6 (trade name, manufactured by Yanaco Bunseki Kogyo Co.)

### [Weight Average Molecular Weight]

Gel permeation chromatography (GPC) analysis with the following apparatus and the like was used to determine the weight average molecular weight (Mw) in terms of polystyrene.

Apparatus: Shodex GPC-101 type (trade name, manufactured by Showa Denko K. K.)
Column: KF-80M x 3

Eluent: THF 1 mL/min
Temperature: 40°C

[Solubility]

The amount of the compound dissolved in propylene glycol monomethyl ether acetate (PGMEA) was measured at 23°C, and the results were each evaluated in terms of the solubility according to the following criteria.

Evaluation A: 20% by mass or more
Evaluation B: less than 20% by mass

<Synthesis Example 1> Synthesis of cyanic acid ester compound (hereinafter, also abbreviated as "NMNCN".) of naphthol-modified naphthalene formaldehyde resin

(Synthesis of naphthalene formaldehyde resin)

Stirred were 1277 g (15.8 mol as formaldehyde, produced by Mitsubishi Gas Chemical Company, Inc.) of a 37% by mass aqueous formalin solution and 634 g of 98% by mass sulfuric acid (produced by Mitsubishi Gas Chemical Company, Inc.) under ordinary pressure with refluxing at around 100°C, 553 g (3.5 mol, produced by Mitsubishi Gas Chemical Company, Inc.) of 1-naphthalene methanol dissolved was dropped thereinto over 4 hours, and the reaction was allowed to run for additional 2 hours. To the resulting reaction solution were added 500 g of ethylbenzene (produced by Wako Pure Chemical Industries, Ltd.) and 500 g of methyl isobutyl ketone (produced by Wako Pure Chemical Industries, Ltd.) as dilution solvents, left to stand, and then an aqueous phase being a bottom phase was removed. Furthermore, the reaction solution was neutralized and washed with water, and ethylbenzene and methyl isobutyl ketone were distilled off under reduced pressure, thereby providing 624 g of a naphthalene formaldehyde resin as a light-yellow solid.

(Synthesis of naphthol-modified naphthalene formaldehyde resin)

After 500 g (the number of moles of oxygen contained: 3.9 mol) of the naphthalene formaldehyde resin obtained above and 1395 g (9.7 mol, produced by Sugai Chemical Ind. Co., Ltd.) of naphthol were heated and molten at 100°C, 200 mg of p-toluenesulfonic acid (produced by Wako Pure Chemical Industries, Ltd.) was added with stirring, to initiate the reaction. While the temperature was raised to 170°C, the reaction was allowed to run for 2.5 hours. Thereafter, the resulting reaction solution was diluted with 2500 g of a mixed solvent (m-xylene (produced by Mitsubishi Gas Chemical Company, Inc.)/methyl isobutyl ketone (produced by Wako Pure Chemical Industries, Ltd.) = 1/1 (mass ratio)), and then neutralized and washed with water, and the solvent and the unreacted raw materials were removed under reduced pressure, to provide 1125 g of a naphthol-modified naphthalene formaldehyde resin represented by the following formula (11) as a blackish brown solid. The OH value of the resulting naphthol-modified naphthalene formaldehyde resin was 232 mgKOH/ g (OH group equivalent: 241 g/eq.).

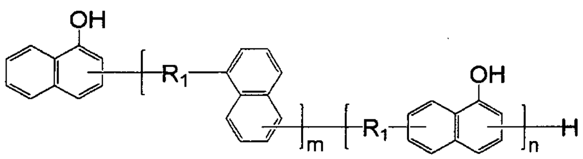

(1 1)

In formula (11), $R_1$, m and n are the same as those described in the formula (1).

(Synthesis of NMNCN)

In 4041 g of dichloromethane were dissolved 730 g (OH group equivalent: 241 g/eq.) (3.03 mol in terms of OH group) (weight average molecular weight Mw: 390) of the naphthol-modified naphthalene formaldehyde resin represented by the formula (11), obtained by the above method, and 459.8 g (4.54 mol) (1.5 mol per 1 mol of hydroxy group) of triethylamine to thereby provide solution 1. While 298.4 g (4.85 mol) (1.6 mol per 1 mol of hydroxy group) of cyanogen chloride, 661.6 g of dichloromethane, 460.2 g (4.54 mol) (1.5 mol per 1 mol of hydroxyl group) of 36% hydrochloric acid and 2853.2 g of water were stirred, solution 1 was injected thereto over 72 minutes with the liquid temperature being kept at -2 to -0.5°C. After completion of injection of solution 1, the resultant was stirred at that temperature for 30 minutes,

and thereafter a solution (solution 2) in which 183.9 g (1.82 mol) (0.6 mol per 1 mol of hydroxyl group) of triethylamine was dissolved in 184 g of dichloromethane was injected thereto over 25 minutes. After completion of injection of solution 2, the resultant was stirred at that temperature for 30 minutes to complete the reaction.

Thereafter, the reaction solution was left to stand to separate an organic phase and an aqueous phase. The resulting organic phase was washed with 2000 g of water five times. The electrical conductivity of the water discharged at the fifth washing with water was 20 μS/cm, and it was thus confirmed that an ionic compound that could be removed was sufficiently removed by washing with water.

The organic phase after washing with water was concentrated under reduced pressure, and finally concentrated to dryness at 90°C for 1 hour, to provide 797 g of a cyanic acid ester compound (brown viscous matter) represented by the following formula (1-2) (the representative composition of the cyanic acid ester compound corresponded to a compound represented by the following formula (10).). The weight average molecular weight Mw of the resulting cyanic acid ester compound (NMNCN) was 490. In addition, the IR spectrum of the NMNCN exhibited an absorption at 2260 $cm^{-1}$ (cyanic acid ester group), and no absorption of a hydroxy group. As a result of thermogravimetric measurement (TG), the 20% thermal weight loss temperature of the resulting cyanic acid ester compound (NMNCN) was 400°C or higher. Therefore, the compound was evaluated to have a high heat resistance and be applicable to high-temperature baking. As a result of evaluation of the solubility in PGMEA, the solubility was 20% by mass or more (Evaluation A) and the cyanic acid ester compound (NMNCN) was evaluated to have an excellent solubility. Therefore, the cyanic acid ester compound (NMNCN) was evaluated to have a high storage stability in a solution state and also be sufficiently applicable to an edge bead rinse liquid (mixed liquid of PGME/PGMEA) widely used in a semiconductor microfabrication process.

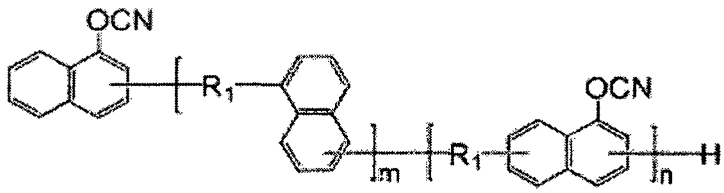
(1 − 2)

In formula (1-2), $R_1$, m and n are the same as those described in the formula (1).

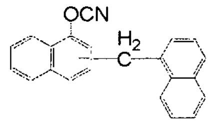

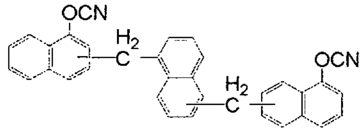

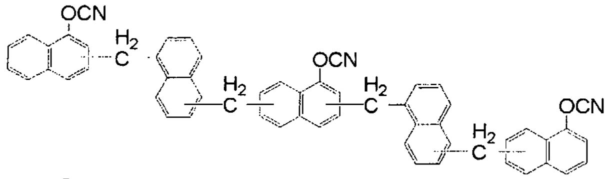

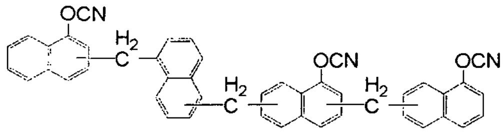

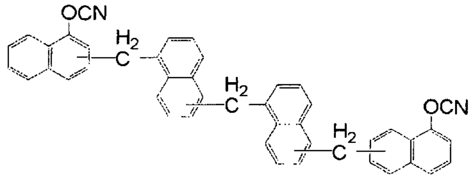

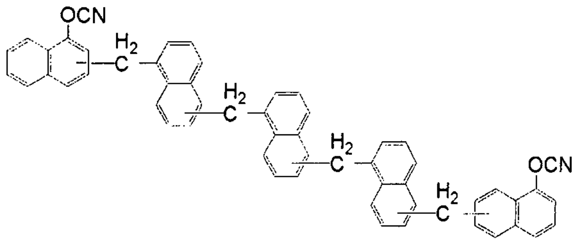

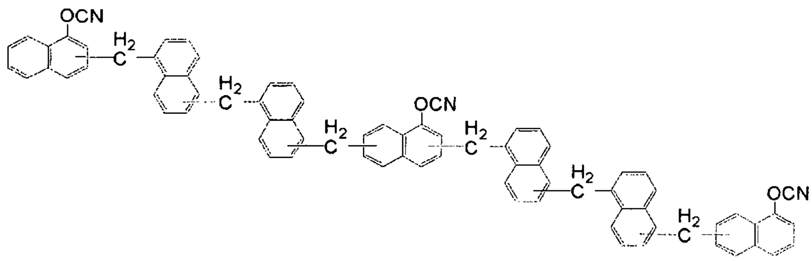

(1 0)

<Production Example 1> Production of modified resin (hereinafter, also abbreviated as "CR-1".)

A four-neck flask having a bottom outlet and an inner volume of 10 L, equipped with a Dimroth condenser, a thermometer and a stirring blade was prepared. To this four-neck flask were charged 1.09 kg (7 mol, produced by Mitsubishi Gas Chemical Company, Inc.) of 1,5-dimethylnaphthalene, 2.1 kg (28 mol as formaldehyde, produced by Mitsubishi Gas Chemical Company, Inc.) of a 40% by mass aqueous formalin solution and 0.97 ml of 98% by mass sulfuric acid (produced by Kanto Chemical Co., Inc.) under a nitrogen stream, and allowed the reaction to run under ordinary pressure for 7 hours with refluxing at 100°C. Thereafter, ethylbenzene (special grade chemical, produced by Wako Pure Chemical Industries, Ltd.) (1.8 kg) as a dilution solvent was added to the reaction solution and left to stand, and then an aqueous phase being a bottom phase was removed. Furthermore, the resultant was neutralized and washed with water, and ethylbenzene and the unreacted 1,5-dimethylnaphthalene were distilled off under reduced pressure, thereby providing 1.25 kg of a dimethylnaphthalene formaldehyde resin as a light-brown solid. With respect to the molecular weight of the resulting dimethylnaphthalene formaldehyde, Mn was 562, Mw was 1168 and Mw/Mn was 2.08. In addition, the carbon concentration was 84.2% by mass, and the oxygen concentration was 8.3% by mass.

Subsequently, a four-neck flask having an inner volume of 0.5 L, equipped with a Dimroth condenser, a thermometer and a stirring blade, was prepared. To this four-neck flask were charged 100 g (0.51 mol) of the dimethylnaphthalene formaldehyde resin obtained as described above and 0.05 g of paratoluenesulfonic acid under a nitrogen stream, heated for 2 hours with the temperature being raised to 190°C, and then stirred. Thereafter, 52.0 g (0.36 mol) of 1-naphthol was further added thereto, and further heated to 220°C to allow the reaction to run for 2 hours. After being diluted with a solvent, the resultant was neutralized and washed with water, and the solvent was removed under reduced pressure to thereby provide 126.1 g of a modified resin (CR-1) as a blackish brown solid. With respect to the resulting modified resin (CR-1), Mn was 885, Mw was 2220 and Mw/Mn was 4.17. In addition, the carbon concentration was 89.1% by mass and the oxygen concentration was 4.5% by mass. As a result of evaluation of the solubility in PGMEA, the solubility was 20% by mass or more (Evaluation A) and the modified resin was evaluated to have an excellent solubility.

<Examples 1 to 2 and Comparative Examples 1 to 2>

A material for forming an underlayer film for lithography in each of Examples 1 to 2 and Comparative Examples 1 to 2 was prepared using the cyanic acid ester compound (NMNCN) obtained in Synthesis Example 1 above, the modified resin (PGMEA) obtained in Production Example 1 above, and the following materials so that each composition shown in Table 1 was achieved.

Acid generator: di-tert-butyldiphenyliodonium nonafluoromethanesulfonate (DTDPI) produced by Midori Kagaku Co., Ltd.

Crosslinking agent: Nikalac MX270 (Nikalac) produced by Sanwa Chemical Co., Ltd.

Organic solvent: propylene glycol monomethyl ether acetate (PGMEA)

[Table 1]

| | Material for forming underlayer film (parts by mass) | Solvent (parts by mass) | Acid generator (parts by mass) | Crosslinking agent (parts by mass) | Etching resistance | Heat resistance |
|---|---|---|---|---|---|---|
| Example 1 | NMNCN (10) | PGMEA (90) | - | - | A | A |
| Example 2 | NMNCN (10) | PGMEA (90) | DTDPI (0.5) | Nikalac (0.5) | B | B |
| Comparative Example 1 | CR-1 (10) | PGMEA (90) | DTDPI (0.5) | Nikalac (0.5) | C | C |
| Comparative Example 2 | CR-1 (10) | PGMEA (90) | - | - | C | C |

Then, each composition for forming an underlayer film of Examples 1 to 2 and Comparative Examples 1 to 2 was spin-coated on a silicon substrate, thereafter baked at 180°C for 60 seconds and further at 400°C for 120 seconds to prepare each underlayer film having a thickness of 200 nm. Then, the following [Etching resistance] and [Heat resistance] were evaluated under conditions of [Etching test] shown below.

[Etching Test]

Etching apparatus: RIE-10NR manufactured by Samco Inc.

Output: 50 W
Pressure: 4 Pa
Time: 2 min
Etching gas
$CF_4$ gas flow rate : $O_2$ gas flow rate = 5 : 15 (sccm)

[Etching Resistance]

The evaluation of etching resistance was performed according to the following procedure. First, an underlayer

film of novolac was prepared under the same conditions as those in Example 1 except that novolac (PSM4357 produced by Gunei Chemical Industry Co., Ltd.) was used instead of the compound (NMNCN) in Example 1 and the drying temperature was changed to 110°C. Then, the etching test was performed with respect to the underlayer film of novolac as a subject, and the etching rate in that time was measured.

Then, the etching test was performed with respect to each underlayer film of Examples 1 to 2 and Comparative Examples 1 to 2 as a subject, and the etching rate in that time was measured. Then, the etching resistances were evaluated according to the following criteria based on the etching rate of the underlayer film of novolac. Evaluation A or Evaluation B below is preferable in terms of practical use.

<Evaluation Criteria>

Evaluation A: etching rate of less than -20% compared with the etching rate of the underlayer film of novolac
Evaluation B: etching rate of -20% or more and -10% or less compared with the etching rate of the underlayer film of novolac
Evaluation C: etching rate of -10% or more and 0% or less compared with the etching rate of the underlayer film of novolac

[Heat resistance]

An EXSTAR 6000 TG-DTA (trade name) apparatus manufactured by SII NanoTechnology Inc. was used, and about 5 mg of a sample was placed in an unsealed aluminum container and heated to 500°C at a rate of temperature rise of 10°C/min in a nitrogen gas (300 mL/min) stream to thereby measure the heat weight loss. Evaluation A or Evaluation B below is preferable in terms of practical use.

<Evaluation Criteria>

Evaluation A: heat weight loss at 400°C of less than 20%

Evaluation B: heat weight loss at 400°C of 20% or more and 30% or less

Evaluation C: heat weight loss at 400°C of more than 30%

<Example 3>

The composition for forming an underlayer film for lithography in Example 1 was coated on a $SiO_2$ substrate having a film thickness of 300 nm, and baked at 240°C for 60 seconds and further at 400°C for 120 seconds to thereby form an underlayer film having a film thickness of 70 nm. A resist solution for ArF was coated on the underlayer film, and baked at 130°C for 60 seconds to thereby form a photoresist layer having a film thickness of 140 nm. As the resist solution for ArF, one prepared by blending 5 parts by mass of the compound of the following formula (12), 1 part by mass of triphenylsulfonium nonafluoromethanesulfonate, 2 parts by mass of tributylamine, and 92 parts by mass of PGMEA was used.

A compound of following formula (12) was prepared as follows. That is, 4.15 g of 2-methyl-2-methacryloyloxyadamantane, 3.00 g of methacryloyloxy-γ-butyrolactone, 2.08 g of 3-hydroxy-1-adamantyl methacrylate and 0.38 g of azobisisobutyronitrile were dissolved in 80 mL of tetrahydrofuran to provide a reaction solution. This reaction solution was subjected to polymerization under a nitrogen atmosphere for 22 hours with the reaction temperature being kept at 63°C, and thereafter the reaction solution was dropped in 400 mL of n-hexane. A product resin thus obtained was solidified and purified, and a white powder produced was taken by filtration and dried under reduced pressure at 40°C overnight to provide a compound represented by the following formula.

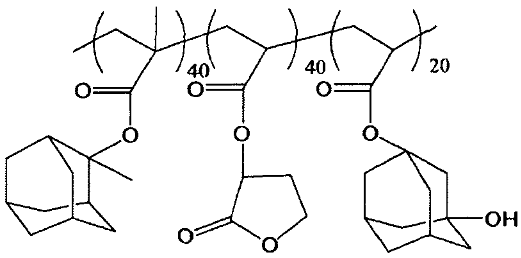

(1 2)

In the formula (12), the numerals 40, 40, and 20 indicate the proportions of the respective constituent units, and do not mean a block copolymer.

Then, the photoresist layer was exposed by using an electron beam lithography apparatus (ELS-7500, produced by Elionix, Inc., 50 keV), baked at 115°C for 90 seconds (PEB), and developed with a 2.38% by mass aqueous tetramethylammonium hydroxide (TMAH) solution for 60 seconds, thereby providing a positive-type resist pattern. The evaluation results are shown in Table 2.

<Example 4>

Except that the composition for forming an underlayer film for lithography in Example 2 was used instead of the composition for forming an underlayer film for lithography in Example 1, the same manner as in Example 3 was performed to provide a positive-type resist pattern. The evaluation results are shown in Table 2.

<Comparative Example 3>

Except that no underlayer film was formed, the same manner as in Example 3 was performed to form a photoresist layer directly on a SiO2 substrate to provide a positive-type resist pattern. The evaluation results are shown in Table 2.

[Evaluation]

The shapes of the resist patterns of 55 nm L/S (1 : 1) and 80 nm L/S (1 : 1) provided in each of Examples 3, 4 and Comparative Example 3 were observed by using an electron microscope (S-4800) manufactured by Hitachi Ltd. A case where the shape of the resist pattern after development had no pattern collapse and had good rectangularity was evaluated to be good and a case the shape had pattern collapse and did not have good rectangularity was evaluated to be poor. In the observation results, the minimum line width where there was no pattern collapse and rectangularity was good was defined as the resolution and used as an evaluation index. Furthermore, the minimum amount of electron beam energy, where a good pattern shape could be drawn, was defined as the sensitivity and used as an evaluation index.

[Table 2]

| | Composition for forming underlayer film | Resolution (nmL/S) | Sensitivity (μC/cm$^2$) | Resist pattern shape after development |
|---|---|---|---|---|
| Example 3 | Composition described in Example 1 | 55 | 16 | Good |
| Example 4 | Composition described in Example 2 | 56 | 16 | Good |
| Comparative Example 3 | Not used | 80 | 38 | Not good |

As can be seen from Table 2, it was at least confirmed that Examples 3 and 4 in which the composition for forming an underlayer film, including the cyanic acid ester compound, were significantly excellent in both of resolution and sensitivity as compared with Comparative Example 3 in which no composition for forming an underlayer film was used. It was also at least confirmed that the resist pattern shape after development had no pattern collapse and had good rectangularity. Furthermore, it was at least confirmed from the difference in the resist pattern shape after development that the underlayer film obtained from the composition for an underlayer film for lithography in each of Examples

3 and 4 had good adhesiveness with a resist material.

The present application is based on Japanese Patent Application (Japanese Patent Application No. 2015-041370) filed on March 3, 2015, the content of which is herein incorporated as reference.

The material for forming an underlayer film for lithography according to the present invention has a relatively high heat resistance and also a relatively high solvent solubility, is excellent in embedding property in a stepped substrate or the like and film flatness, and can be applied to a wet process. Therefore, the material for forming an underlayer film for lithography, and the composition including the material and the underlayer film formed using the composition, according to the present invention, can be widely and effectively utilized in various applications in which these properties are required.

## Claims

1. A material for forming an underlayer film for lithography, comprising a cyanic acid ester compound obtained by cyanation of a modified naphthalene formaldehyde resin.

2. The material for forming the underlayer film for lithography according to claim 1, wherein the cyanic acid ester compound is a compound represented by following formula (1),

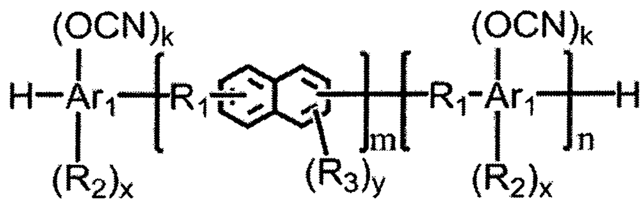

(1)

wherein each $Ar_1$ independently represents an aromatic ring structure, each $R_1$ independently represents a methylene group, a methyleneoxy group, a methyleneoxymethylene group or an oxymethylene group, or a combination thereof, each $R_2$ independently represents a hydrogen atom, an alkyl group or an aryl group as a monovalent substituent, each $R_3$ independently represents an alkyl group having 1 to 3 carbon atoms, an aryl group, a hydroxy group, or a hydroxymethylene group, m represents an integer of 1 or more, n represents an integer of 0 or more, each repeating unit is arranged in any manner; k represents an integer of 1 to 3 as the number of cyanato group(s) bonded, x represents an integer of "the number of $Ar_1$ which can be bonded - (k+2)" as the number of $R_2$ bonded, and y represents an integer of 0 to 4.

3. The material for forming the underlayer film for lithography according to claim 1 or 2, wherein the modified naphthalene formaldehyde resin is a resin obtained by modifying a naphthalene formaldehyde resin or a deacetalized naphthalene formaldehyde resin by use of a hydroxy-substituted aromatic compound.

4. The material for forming the underlayer film for lithography according to claim 3, wherein the hydroxy-substituted aromatic compound is at least one selected from the group consisting of phenol, 2,6-xylenol, naphthol, dihydroxynaphthalene, biphenol, hydroxyanthracene and dihydroxyanthracene.

5. The material for forming the underlayer film for lithography according to any one of claims 1 to 4, wherein a weight average molecular weight of the cyanic acid ester compound is 200 or more and 25000 or less.

6. The material for forming the underlayer film for lithography according to any one of claims 2 to 5, wherein the compound represented by the formula (1) is a compound represented by following formula (1-1),

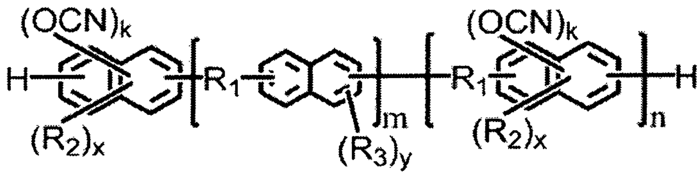

(1 − 1)

wherein $R_1$ to $R_3$, k, m, n and y are the same as those described in the formula (1), and x represents an integer of (6-k).

**7.** The material for forming the underlayer film for lithography according to claim 6, wherein the compound represented by the formula (1-1) is a compound represented by following formula (1-2),

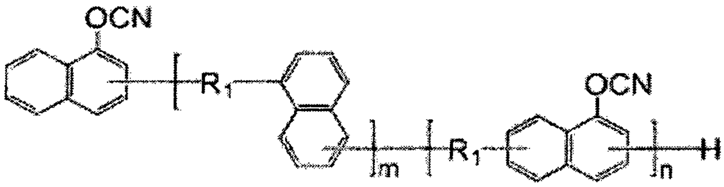

(1 − 2)

wherein $R_1$, m and n are the same as those described in the formula (1).

**8.** A composition for forming an underlayer film for lithography, comprising the material for forming the underlayer film for lithography according to any one of claims 1 to 7, and a solvent.

**9.** The composition for forming the underlayer film for lithography according to claim 8, further comprising an acid generator.

**10.** The composition for forming the underlayer film for lithography according to claim 8 or 9, further comprising a crosslinking agent.

**11.** An underlayer film for lithography, formed using the composition for forming the underlayer film for lithography according to any one of claims 8 to 10.

**12.** A resist pattern forming method comprising:

a step of forming an underlayer film on a substrate by using the composition for forming the underlayer film according to any one of claims 8 to 10;
a step of forming at least one photoresist layer on the underlayer film; and
a step of irradiating a predetermined region of the photoresist layer with radiation, and developing it.

**13.** A circuit pattern forming method comprising:

a step of forming an underlayer film on a substrate by using the composition for forming the underlayer film according to any one of claims 8 to 10;
a step of forming an intermediate layer film on the underlayer film by using a silicon atom-containing resist intermediate layer film material;
a step of forming at least one photoresist layer on the intermediate layer film;
a step of irradiating a predetermined region of the photoresist layer with radiation, to form a resist pattern by developing;
a step of etching the intermediate layer film with the resist pattern as a mask, to form an intermediate layer film pattern;
a step of etching the underlayer film with the intermediate layer film pattern as an etching mask, to form an underlayer film pattern; and
a step of etching the substrate with the underlayer film pattern as an etching mask, to form a substrate pattern.

**INTERNATIONAL SEARCH REPORT**

International application No. PCT/JP2016/054824

A. CLASSIFICATION OF SUBJECT MATTER
*G03F7/11*(2006.01)i, *C08G14/12*(2006.01)i, *G03F7/40*(2006.01)i, *H01L21/027*(2006.01)i

According to International Patent Classification (IPC) or to both national classification and IPC

B. FIELDS SEARCHED

Minimum documentation searched (classification system followed by classification symbols)
G03F7/11, C08G14/12, G03F7/40, H01L21/027

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | US 2014/0227887 A1 (KIM,Jeong-Sik),<br>14 August 2014 (14.08.2014),<br>paragraphs [0015], [0041] to [0044]; tables 1, 2; example 3; formula 1e<br>& WO 2013/036027 A & KR 10-2013-0026761 A<br>& TW 201319756 A & CN 103781816 A | 1,5,8-12<br>13<br>2-4,6-7 |
| X<br>Y<br>A | WO 2009/072465 A1 (Mitsubishi Gas Chemical Co., Inc.),<br>11 June 2009 (11.06.2009),<br>example 20; paragraphs [0133] to [0134], [0179]<br>& JP 5370158 B & US 2010/0324255 A1<br>example 20; paragraphs [0139] to [0140], [0186]<br>& WO 2009/072465 A1 & EP 2236530 A1<br>& CN 101889247 A & KR 10-2010-0108512 A<br>& TW 200925785 A | 1,5,8-13<br>13<br>2-4,6-7 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 25 April 2016 (25.04.16) | 17 May 2016 (17.05.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | <br>Telephone No. |

Form PCT/ISA/210 (second sheet) (January 2015)

**INTERNATIONAL SEARCH REPORT**

International application No. PCT/JP2016/054824

C (Continuation). DOCUMENTS CONSIDERED TO BE RELEVANT

| Category* | Citation of document, with indication, where appropriate, of the relevant passages | Relevant to claim No. |
|---|---|---|
| A | JP 2006-193607 A (Mitsubishi Gas Chemical Co., Inc.), 27 July 2006 (27.07.2006), entire text & KR 10-2006-0082822 A & CN 1803916 A & TW I391446 B | 1-13 |
| A | JP 2012-212051 A (Toyo Ink SC Holdings Co., Ltd.), 01 November 2012 (01.11.2012), entire text (Family: none) | 1-13 |
| A | JP 2010-189470 A (Hitachi Chemical Co., Ltd.), 02 September 2010 (02.09.2010), entire text (Family: none) | 1-13 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004177668 A
- JP 2004271838 A
- JP 2005250434 A
- WO 2009072465 A
- WO 2011034062 A
- JP 2002334869 A
- WO 2004066377 A
- JP 2007226170 A
- JP 2007226204 A
- US 3553244 A
- JP 3319061 B
- JP 3905559 B
- JP 4055210 B
- JP 2991054 B
- JP 5026727 B
- JP 2015041370 A